# EUROPEAN PATENT APPLICATION

(11) **EP 1 804 286 A1**
(43) Date of publication of application: **04.07.2007**
(21) Application number: 05077991.7
(22) Date of filing: 27.12.2005
(51) Int. Cl.: H01L 21/336, H01L 21/335, H01L 29/786, H01L 29/06

(54) **Elongate nanostructure semiconductor device**

(71) Applicant: Interuniversitair Microelektronica Centrum, 3001 Leuven (BE)
(72) Inventor: Verhulst, Anne, 2235 Houtvenne (BE); Vereecken, Philippe M., 3000 Leuven (BE); Iriarte, Gonzalo Fuentes, 3000 Leuven (BE); Maex, Karen, 3020 Herent (BE)
(74) Representative: Bird, William Edward

(57) **Abstract**

The invention discloses the creation of elongate nanostructure semiconductor devices comprising at least a first and second device structure on top of one another, of which at least the first is a transistor structure and at least the second is a nanostructure device structure comprising a vertical elongate nanostructure (20). For the application in e.g. a field-effect-transistor the at least one elongate nanostructure (20) forms the channel of the field-effect transistor.

The present invention furthermore provides a method whereby the vertical growth of elongate nanostructures is used to fabricate a vertical elongate nanostructure semiconductor device, e.g. a vertical surround-gate elongate nanostructure field-effect-transistor, according to the present invention. Also several possible devices are disclosed which comprise vertical stacks of device structures, of which at least the first is a transistor structure and at least the second is an elongate nanostructure device structure comprising a vertical elongate nanostructure (20).

## Description

### Field of the invention

The present disclosure is related to the field of semiconductor device architectures and semiconductor processing. More specifically, the invention is related to a nanostructure semiconductor device, e.g. a nanostructure transistor especially a transistor with a nanowire channel such as a surround-gate nanowire field-effect-transistor (FET), and a method for manufacturing such nanowire semiconductor devices with integrated nanowires forming a channel of the semiconductor device.

### Background of the invention

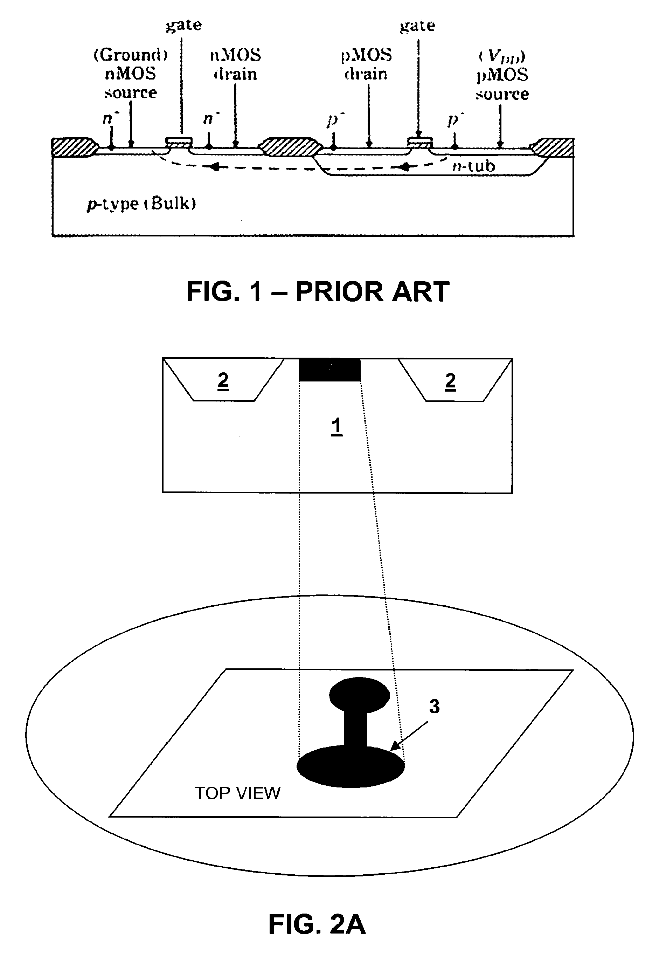

The maximum transistor density, achievable by scaling down planar Metal-Oxide-Semiconductor field-effect transistors (MOSFET) is limited by the two-dimensional surface area of a chip. Transistors are all located next to one another in, e.g. a single-crystal silicon substrate. Part of the space on the substrate is also dedicated to decreasing parasitic coupling between neighboring transistors. Such parasitic couplings, like e.g. latch-up (see Figure 1), often come into place via the common substrate. Solutions to overcome these parasitic couplings are e.g. based on the use of guard rings, trenches and retrograde wells. However, these solutions further increase the required space per transistor.

Conventional device fabrication within the semiconductor industry is limited to a two-dimensional surface area because the starting point for device fabrication is usually a single-crystal silicon substrate. It is not easy to grow/deposit monocrystalline material onto the substrate for continued device fabrication due to very high temperatures required for epitaxial growth or for crystallization of non-crystalline silicon. However, in the form of elongate nanostructures, e.g. nanowires, crystalline growth of material is possible at significantly lower temperatures. Nanowires, which are single crystalline wires with diameters in the nanoscale, grow onto substrates of different materials and can grow to form single crystalline nanowires even when the substrate is not single crystalline.

In the prior art several suggestions are made to incorporate nanowires in a semiconductor device but none of them exploit the full 3D capabilities offered by e.g. semiconducting nanowires.

US 2004/0031975 A1 describes a field effect transistor (FET) memory cell with a channel region formed by at least one nanowire which has at least one defect and a method to produce such a memory cell by forming a nanowire with a defect. In this method only a horizontal nanowire is considered because the method of fabrication is to disperse prefabricated nanowires on a substrate. The density of nanowires in the device is therefore still limited to the two-dimensional surface area of the substrate.

US 6,798,000 B2 describes a FET comprising a first nanowire, the FET having a source, drain and channel region and at least one nanotube which forms a gate region, as well as a method to produce such a field-effect-transistor. The FET according to this document has a small surface area. Also here the density of nanostructures in the device is limited to the two-dimensional surface area of the substrate.

US 6,740,910 B2 describes a method to produce a field-effect-transistor with a vertical channel. The proposed structure has the source underneath the nanowire and the drain on top of it. The nanowires or nanotubes are grown in through holes formed in the gate electrode and hence the nanowires or nanotubes are surrounded by the gate electrode. The obtained device includes a vertical transistor comprising nanowires, but again here the density is limited to the two-dimensional surface area of the substrate.

In "Single Crystal Nanowire Vertical Surround-Gate Field-Effect Transistor", (Nanoletters 4, 1247, 2004) Ng H.T. et al. describe a method to form a single crystal nanowire vertical surround-gate field-effect transistor formed by growing a nanostructure on top of a substrate (using a bottom-up approach as it is called in the disclosure). Unlike traditional (called top-down in the disclosure) approaches relying on reactive-ion etching, the favorable straight sidewall profile of the nanostructure is well maintained. However, also here the density of the nanostructures is limited to the two-dimensional surface area of the substrate.

In "Vertical nanowire transistor in flexible polymer foil", (Appl. Phys. Lett. 82, 4782, 2003), Chen J. et al. describe a method to form a vertical nanowire transistor on a flexible polymer foil stack. The polymer foil stack consists of two polymer layers and an intermediate metal layer. Cylindrical holes are prepared in this stack by using fast ion irradiation and subsequent etching. Vertical nanowires are then grown in the holes formed in the polymer foil stack. Also here the fabrication of the vertical transistor is limited to the two-dimensional surface area of the substrate.

### Summary of the invention

It is an object of the present invention to provide semiconductor device structures with improved architecture using elongate nanostructures such as nanowires, e.g. nanowires as a channel, and to a method for the manufacturing of such semiconductor device structures.

The above objective is accomplished by a method and device according to the present invention.

The invention discloses the creation of vertical stacks of at least two device structures of which at least a first device structure is a transistor device structure and at least a second device structure is a nanostructure device structure comprising at least one vertical elongate nanostructure, e.g. nanowire. The elongate nanostructure, e.g. nanowire, is substantially perpendicular to a plane of a substrate. The nanostructure device structure may comprise one or more vertical elongate nanostructures, e.g. nanowires. More specifically the present invention relates to a nanostructure semiconductor device structure and to a method for the creation thereof, whereby at least one and preferably two or more vertical stacks of device structures as described above are used, such vertical stacks for example representing a logic unit.

With elongate nanostructures are meant any two-dimensionally confined pieces of solid material in the form of wires (nanowires), tubes (nanotubes), rods (nanorods) and similar elongated substantially cylindrical or polygonal structures having a longitudinal axis. A cross-dimension of the elongate nanostructures, e.g. nanowires, preferably lies in the region of 0.2 to 500 nm or 10 to 500 nanometres. According to the invention, organic elongate nanostructures, such as e.g. carbon nanotubes, or inorganic nanowires, such as e.g. semiconductor (e.g. silicon) or metal (e.g platinum) nanowires may be used. With a vertical stack of device structures is meant two device structures which are vertically positioned on top of each other. With vertically positioned is meant that, when the stack of device structures is positioned on a substrate, the substrate lying in a plane, in particular a horizontal plane, the device structures are positioned in a direction such that their longitudinal axis is oriented substantially perpendicular to the plane of the substrate. Furthermore, with a vertical elongate nanostructure is meant, when the elongate nanostructure is positioned on a substrate lying in a plane, that the elongate nanostructure is positioned with its longitudinal axis in a direction substantially perpendicular to the plane of the substrate.

For the application in e.g. field-effect-transistor (FET) devices said elongate nanostructure, e.g. nanowires form the channel of the field-effect transistor.

In a first aspect of the present invention, an elongate nanostructure semiconductor device, which may, for example, be a vertical surround-gate nanowire field-effect-transistor (FET), is disclosed. The elongate nanostructure semiconductor device has a substrate lying in a plane and comprises at least a first and a second device structure positioned on top of each other, wherein at least the first device structure is a transistor structure and at least the second device structures is an elongate nanostructure, e.g. nanowire, device structure comprising at least one elongate nanostructure positioned substantially perpendicular to the plane of the substrate.

According to embodiments of the invention, the at least one elongate nanostructure of the elongate nanostructure device structure may be at least partly surrounded by a gate structure. The gate structure may, for example, be formed of poly-Si, a metal, fully silicided metal (FUSI) or other suitable materials.

In an embodiment according to the first aspect of the present invention, the elongate nanostructure semiconductor device, e.g. vertical surround-gate elongate nanostructure field-effect-transistor (FET), has a substrate lying in a plane and comprises at least a first elongate nanostructure device structure and a second elongate nanostructure device structure, positioned on top of each other. Each elongate nanostructure device structure comprises at least one elongate nanostructure positioned substantially perpendicular to the plane of the substrate, and the at least one elongate nanostructure of at least one of the first and second elongate nanostructure device structures is at least partly surrounded by a gate structure

According to the present invention, the elongate nanostructure semiconductor device may preferably be a vertical surround gate field-effect-transistor acting as an inverter or follower and the at least first and second elongate nanostructure device structures may preferably be nanowire FET structures.

According to embodiments of the invention, the at least one elongate nanostructure of the first elongate nanostructure device structure may be at least partly surrounded by a first gate structure and the at least one elongate nanostructure of the second elongate nanostructure device structure may be at least partly surrounded by a second gate structure. In these preferred embodiments, the first and second gate structures may be connected to each other by means of at least one conductive structure.

According to other embodiments of the invention, the elongate nanostructure semiconductor device may comprise at least one elongate nanostructure device structure of which the at least one elongate nanostructure is not surrounded by a gate structure. In that case, the at least one elongate nanostructure, e.g. nanowire, may preferably be formed of, for example, a metal such as Cu, but may also be formed of any other suitable material to form an elongate nanostructure, e.g. nanowire.

According to embodiments of the invention, the at least one elongate nanostructure may have a length and the gate structure may cover between 10% and 95% of the elongate nanostructure length.

According to embodiments of the invention, the at least one elongate nanostructure may have a length and the gate structure may cover between 10% and 99% of the elongate nanostructure length.

According to embodiments of the invention, the elongate nanostructure may have a length and the gate structure may cover between 60% and 90% of the elongate nanostructure length.

According to embodiments of the invention, the at least one elongate nanostructure may have a length and the gate structure may cover between 60% and 99% of the elongate nanostructure length.

According to embodiments of the present invention, the length of the at least one elongate nanostructure may preferably be between 10 nm and 2 µm, preferably between 20 nm and 2 µm and most preferred may be between 50 nm and 1 µm.

The amount of the elongate nanostructure which is covered by the gate structure may, in general, be determined by a trade-off between a series resistance Rs of the elongate nanostructure and a parasitic capacitance between the gate structure and a first contact, e.g. a source contact, or a second contact, e.g. a drain contact. The resistance of the part of the elongate nanostructure which is not covered by the gate structure may be determined by elongate nanostructure doping and will to first approximation not be influenced by the gate structure since the gate structure does not cover that part of the elongate nanostructure. The longer the non-covered section, the larger the series resistance Rs of the elongate nanostructure. On the other hand, the shorter the non-covered section of the elongate nanostructure, the stronger the capacitive coupling between the gate structure electrode and the first or second contact. The optimal coverage is therefore a trade-off between series resistance and parasitic capacitive coupling and depends on the application.

According to an embodiment of the present invention, the vertical stack of at least two device structures so as to form a logic unit, is made possible by using a vertical stack of elongate nanostructures, e.g. nanowires, whereby the active region of each elongate nanostructure device structure comprises an elongate nanostructure, e.g. nanowire, and whereby the vertical stack of elongate nanostructures is made possible by the vertical crystalline growth of elongate nanostructure on top of previously fabricated structures. Examples of logic units that can be made according to the present invention, the invention, however, not being limited to these examples, are complementary metal-oxide semiconductor field-effect transistor (CMOS), OR-gate, AND-gate, NOT-gate, NOR-gate, NAND-gate, SRAM, etc.

Several possible devices are disclosed whereby vertical stacks of device structures, of which at least one device structure comprises at least one vertical elongate nanostructure, are used to create a logic unit. It has to be noted that in a final device all these logic units can be combined with each other, and combinations of alternating vertical stacks and interconnect metallizations as well as combinations of existing planar devices with vertical surround-gate elongate nanostructure devices can be made.

According to embodiments of the invention, the at least first and second elongate nanostructure device structures may be connected to each other by a common output source.

According to the invention, the at least first and/or second elongate nanostructure device structures may comprise a plurality of elongate nanostructures. The plurality of elongate nanostructures in the first and/or second elongate nanostructure device structure may form a horizontal or a vertical stack. With horizontal stack is meant that the elongate nanostructure device structures are positioned next to each other, i.e. adjacent in a plane parallel to the plane of the substrate. And with vertical stack is meant that the elongate nanostructure device structures are positioned on top of each other.

According to embodiments of the invention, the at least first and second elongate nanostructure device structures may comprise a same or a different number of elongate nanostructure.

According to embodiments of the invention, the first elongate nanostructure device structure may comprise at least one elongate nanostructure of a first type and the second elongate nanostructure device structure may comprise at least one elongate nanostructure of a second type, the first and second type being different from each other. For example, in one embodiment according to the invention, the first elongate nanostructure device structure may comprise at least one n-type (or p-type) elongate nanostructure and the second elongate nanostructure device structure may comprise at least one p-type (or n-type) elongate nanostructure.

In other embodiments according to the invention, the at least one elongate nanostructure of the first elongate nanostructure device structure may be formed of a first material and the at least one elongate nanostructure of the second elongate nanostructure device structure may be formed of a second material, the first and second material being different from each other. For example, the at least one elongate nanostructure of the first elongate nanostructure device structure may be formed of n-type (p-type) indium phosphide (InP) or n-type (p-type) gallium arsenide (GaAs) while the at least one elongate nanostructure of the second elongate nanostructure device structure may be formed of p-type (n-type) silicon (Si) or p-type (n-type) gallium arsenide (GaAs). Any suitable combination of n- and p-type semiconductor materials can be used according to the invention to form the at least one elongate nanostructure of the at least first and second elongate nanostructure device structures

In still other embodiments of the invention, the at least one elongate nanostructure of the first elongate nanostructure device structure may be formed of a n- or p-type semiconducting material while the at least one elongate nanostructure of the second elongate nanostructure device structure may be formed of a metal such as e.g. Cu, or vice versa.

According to embodiments of the invention, the at least one elongate nanostructure of the first elongate nanostructure device structure may have a first diameter and the at least one elongate nanostructure of the second elongate nanostructure device structure may have a second diameter, wherein the first and second diameter may be equal to each other or may be different from each other.

The diameter of the at least one elongate nanostructure may be between 0.2 and 500 nm, preferably between 1 and 500 nm, and most preferred the diameter of the at least one elongate nanostructure may be between 5 and 200 nm.

According to other embodiments of the first aspect of the present invention, the elongate nanostructure semiconductor device may comprise a first device structure and a second device structure, wherein the first device structure is a planar transistor device structure and wherein the second device structure is an elongate nanostructure device structure comprising at least one elongate nanostructure positioned substantially perpendicular to the plane of the substrate. According to embodiments of the invention, the planar transistor device structure may be a planar MOSFET or a planar double-gate MOSFET structure (finFET) or tri-gate MOSFET structure.

An elongate nanostructure semiconductor device according to embodiments of the present invention may be a multiple-separate-gate surround FET transistor comprising at least two gate structures, each gate structure at least partly surrounding a same elongate nanostructure, e.g. nanowire.

In a second aspect of the invention, a method is disclosed to create a semiconductor device comprising a vertical stack of device structures whereby the device is preferably a vertical surround gate field-effect-transistor which may act as an inverter or follower.

The method according to the second aspect of the invention comprises:
- providing a substrate lying in a plane, and
- providing on said substrate a first and second device structure on top of each other, at least the first device structure being a transistor structure and at least the second device structure being an elongate nanostructure device structure comprising at least one elongate nanostructure positioned substantially perpendicular to the plane of the substrate.

According to embodiments of the second aspect of the invention, the method may furthermore comprise providing the at least one elongate nanostructure with a gate structure at least partly surrounding the at least one elongate nanostructure .

In an embodiment according to the second aspect of the present invention, the method may comprise:
- providing a substrate lying in a plane,
- providing a first elongate nanostructure device structure on or in the substrate, the first elongate nanostructure device structure comprising at least one elongate nanostructure positioned substantially perpendicular to the plane of the substrate, and
- providing at least a second elongate nanostructure device structure on top of the first elongate nanostructure device structure, the second elongate nanostructure device structure comprising at least one elongate nanostructure positioned substantially perpendicular to the plane of the substrate, and
- providing the at least one elongate nanostructure of at least one of the first and second elongate nanostructure device structure with a gate structure at least partly surrounding the at least one elongate nanostructure.

Providing at least one elongate nanostructure with a gate structure may be performed by directly providing the elongate nanostructure with a permanent gate structure. Alternatively, providing at least one elongate nanostructure with a gate structure may be performed by first providing the at least one elongate nanostructure with a sacrificial gate structure and thereafter replacing the sacrificial gate structure with a permanent gate structure.

According to an embodiment of the present invention, the at least one elongate nanostructure of the at least first and second elongate nanostructure device structure may each be at least partly surrounded by a gate structure. According to these embodiments, the method may furthermore comprise connecting the first and second gate structure by means of a conductive structure.

Providing a first elongate nanostructure device structure may be performed by
- creating at least one first contact, e.g. source contact, in the substrate, and
- growing an elongate nanostructure surrounded by dielectric material on the first contact, e.g. source contact.

In particular, providing a first elongate nanostructure device structure may be performed as follows. The structure may start (from bottom to top) on a substrate, preferably a silicon substrate, in which at least one first contact, e.g. source contact (Vₛₛ), may be created. Preferably said first contact, e.g. source contact, may be a silicide (such as NiSi, CoSi₂) containing structure, but may also be a germanide containing structure, a metal containing structure, polysilicon or a combination thereof. On said first contact, e.g. source contact, an elongate nanostructure, which is surrounded by dielectric material, is grown, preferably the diameter of said elongate nanostructures may be in the range of 0.2 to 500 nm, preferably in the range of 1 to 500 nm, and most preferred may be in the range of 5 to 200 nm. The length of said elongate nanostructures may preferably be 10 nm up to 2 µm, preferably 20 nm up to 2 µm, and most preferred may be 50 nm up to 1 µm. The dielectric layer or matrix surrounding the elongate nanostructures may be a silicon based oxide (e.g. silicon dioxide (SiO₂) or silicon oxy nitride (SiON)), silicate glass (Tetraethyl Orthosilicate (TEOS)), low-k materials such as SiCOH, Silk^{®} or Black Diamond^{®}.

The at least one elongate nanostructure may also be covered by a thin insulator such as a gate oxide. Examples of suitable gate oxide materials which may be used according to the present invention are SiO₂, SiON, Al₂O₃ and high-k oxides (oxides, nitrided oxides, silicates and nitrided silicates of transition metals such as Hf, Ta, Ti, Nb, V, Y, Zr).

In a method according to an embodiment of the present invention, providing a first elongate nanostructure device structure may be performed by:
- creating at least one first contact, e.g. source contact, in the substrate,
- depositing a first stack of layers on said substrate, the first stack of layers comprising a first etch stop layer and a first dielectric layer,
- depositing a second stack of layers on top of said first stack of layers, the second stack of layers comprising a second etch stop layer, a second dielectric layer and a first hardmask layer,
- creating a gate structure in said second dielectric layer,
- depositing a third stack of layers on top of said second stack of layers, the third stack of layers comprising a third dielectric layer and a second hardmask layer,
- creating a via in said first and second dielectric layer through said gate structure and landing on said first contact, e.g. source contact,
- depositing a gate insulating material, e.g. gate oxide, onto the sidewalls of said via,
- growing an elongate nanostructure in said via such that the gate structure is surrounding the elongate nanostructure and said elongate nanostructure is making contact with said first contact, e.g. source contact,
- depositing a fourth stack of layers on top of the third stack of layers, the fourth stack of layers comprising a fourth dielectric layer and a third hardmask layer,
- creating a second contact, e.g. an output contact, in said fourth dielectric layer such that a first elongate nanostructure device structure is created.

In a method according to embodiment of the present invention, providing a second elongate nanostructure device structure may be performed by steps analogous to the steps for providing a first elongate nanostructure device structure, however now on the second contact. These steps include:
- depositing a first dielectric layer on the first elongate nanostructure device structure,
- depositing a second stack of layers on top of said first dielectric layer, the second stack of layers comprising a second etch stop layer, a second dielectric layer and a first hardmask layer,
- creating a gate structure in said second dielectric layer,
- depositing a third stack of layers on top of said second stack of layers, the third stack of layers comprising a third dielectric layer and a second hardmask layer,
- creating a via in said first and second dielectric layer through said gate structure and landing on said second contact,
- depositing a gate insulating material onto the sidewalls of said via,
- growing an elongate nanostructure in said via such that the gate structure is surrounding the elongate nanostructure and said elongate nanostructure is making contact with said second contact,
- depositing a fourth stack of layers on top of the third stack of layers, the fourth stack of layers comprising a fourth dielectric layer and a third hardmask layer,
- creating a third contact in said fourth dielectric layer such that a second elongate nanostructure device structure is created.

This method may furthermore comprise doping said elongate nanostructure with a doping element such that an at least partly doped elongate nanostructure, i.e. at least partly p-type or an at least partly n-type elongate nanostructure, is achieved, the method comprising the steps of:
- depositing a layer comprising the doping element, thus forming a dopant layer,
- annealing said dopant layer such that a doped elongate nanostructure is obtained, and
- partly removing said dopant layer such that the height of the doped elongate nanostructure equals the height of said fourth hardmask layer.

Depending on the doping profile said at least one elongate nanostructure can be a p-type or n-type doped elongate nanostructure. The dopants can be incorporated during growth of the elongate nanostructure or may be added afterwards by means of an additional doping step.

In the same level of stacking both n-type and p-type elongate nanostructures can be formed by subsequent processing in the same dielectric level, requiring separate lithographic steps. Said stacking of elongate nanostructures in the same (dielectric) level will in this application also be referred to as horizontal stacking of elongate nanostructures.

According to the invention, providing a first and at least second elongate nanostructure device structure may be performed such that at least part of the first and second elongate nanostructure device structure is at least partly surrounded by respectively a first and second gate structure, which may also be referred to as a surround gate. Preferably, the gate structure is all-around the elongate nanostructure but this is not necessary. According to embodiments of the invention, the at least one elongate nanostructure has a length and 10% to 95%, or 10% to 99%, or 60% to 90%, or 60% to 99% of the elongate nanostructure length may be covered by said gate structure.

The amount of the elongate nanostructure which is covered by the gate structure may, in general, be determined by a trade-off between a series resistance Rs of the elongate nanostructure and a parasitic capacitance between the gate structure and a first contact, e.g. source contact, or a second contact, e.g. drain contact. The resistance of the part of the elongate nanostructure which is not covered by the gate structure may be determined by the elongate nanostructure doping and will to first approximation not be influenced by the gate structure since the gate structure does not cover the elongate nanostructure. The longer the non-covered section, the larger the series resistance Rs of the elongate nanostructure. On the other hand, the shorter the non-covered section of the elongate nanostructure, the stronger the capacitive coupling between the gate structure electrode and the first contact or second contact. The optimal coverage is therefore a trade-off between series resistance and parasitic capacitive coupling and depends on the application.

According to the second aspect of the invention, for forming a gate structure surrounding the at least one elongate nanostructure of at least one of the first and second elongate nanostructure device structures, two different approaches can be used. In one preferred approach, the gate structure may be a permanent gate structure made of e.g. poly-Si, a metal, or fully silicided metal (FUSI) etc. In another preferred approach, first a sacrificial gate may be formed (e.g. made of SiGe, Ge or low-k) which may then be replaced during further processing by a permanent gate structure.

The at least one elongate nanostructure of the elongate nanostructure device structure may, according to the most preferred embodiment of the invention, connect to a second contact, e.g. an output contact Vₒᵤₜ, of the field-effect transistor. The second contact, e.g. output contact, may preferably be formed of a silicide containing structure, but may also be formed of a germanide containing structure, a metal containing structure, polysilicon or a combination thereof. In that way, a first functional entity, namely a doped, n-type or p-type, elongate nanostructure device structure, may be formed. The active region of the elongate nanostructure device structure thus comprises a elongate nanostructure, which forms the channel of the elongate nanostructure device structure,.

According to an embodiment of the invention, at least a second device structure can be formed on top of this first elongate nanostructure device structure. Starting on the second contact, e.g. output contact, a second doped, p-type or n-type, elongate nanostructure structure may be formed. The elongate nanostructure of the second elongate nanostructure device structure may be surrounded by dielectric material and may, preferably, at least partly be surrounded by a second gate structure (also referred to as a surround gate). This second gate structure can be a poly-Si gate, a metal gate, a FUSI gate, etc. The second elongate nanostructure may, according to the most preferred embodiment, connect to a third contact, e.g. drain contact V_{dd}, of the field-effect transistor. The third contact, e.g. drain contact, may preferably be formed of a silicide containing structure, but may also be formed of a germanide containing structure, a metal containing structure, polysilicon or a combination thereof. This second device structure also represents a p-type or n-type elongate nanostructure device structure. The active region of this second elongate nanostructure device structure also comprises at least one elongate nanostructure, which may form the channel of the elongate nanostructure device structure.

According to embodiments of the invention, the at least one elongate nanostructure of the first and second elongate nanostructure device structure may at least partly be surrounded by respectively a first and second gate structure and the first gate structure and the second gate structure can be connected to each other by means of a vertical hole or via filled up with a conductive material (e.g. a copper or tungsten via), similar to metal contacts and interconnect structures used in back end of line (BEOL) processing.

The final device structure obtained by combining the first and second elongate nanostructure device structures can, in case the first and second elongate nanostructure device structures are first and second elongate nanostructure FET structures, e.g. nanowire FET structures, be referred to as a vertical surround-gate complementary field-effect-transistor, which acts as an inverter or follower depending on the position of n-type and p-type elongate nanostructure.

In an alternative embodiment an elongate nanostructure semiconductor device, e.g. a vertical surround-gate field-effect-transistor, is disclosed in which two or more vertical elongate nanostructure semiconductor devices, e.g. vertical surround-gate complementary field-effect-transistor units, as described in the previous embodiment may be sequentially connected to each other. The output of the first device structure is then the input to the second device structure, etc.

In another alternative embodiment, an elongate nanostructure semiconductor device, e.g. a vertical surround-gate field-effect-transistor, is disclosed in which the number of elongate nanostructures in the first and second elongate nanostructure device structure as described in previous embodiments, may be larger than 1.

In another alternative embodiment, an elongate nanostructure semiconductor device, e.g. a vertical surround-gate field-effect-transistor, is disclosed in which the diameter of the individual elongate nanostructures in an elongate nanostructure device structure, e.g. a nanowire FET structure, as described in previous embodiments may be different.

In still another alternative embodiment, an elongate nanostructure semiconductor device, e.g. a vertical surround-gate field-effect-transistor, is disclosed in which the number of vertical stacks of individual elongate nanostructure device structures, e.g. nanowire FET structures, as described in previous embodiments may be increased.

As an alternative structure, an elongate nanostructure semiconductor device, e.g. a vertical surround-gate field-effect-transistor, is disclosed with only one elongate nanostructure device structure, e.g. a nanowire FET structure.

In another alternative embodiment, an elongate nanostructure semiconductor device, e.g. a vertical surround-gate field-effect-transistor, is disclosed in which more than one surround gate structure is connected to an individual elongate nanostructure device structure, e.g. nanowire FET structure. The simplest structure of such an embodiment is having two gates positioned on a same elongate nanostructure.

In another alternative embodiment, a combination of an elongate nanostructure device structure comprising a vertical elongate nanostructure with a planar transistor device structure, e.g. a planar MOSFET or a planar double-gate MOSFET structure (FinFET) or tri-gate MOSFET, is disclosed. Elongate nanostructure device structures can be grown starting on a substrate that already comprises planar transistor device structures such as e.g. planar MOSFET or planar FinFET or tri-gate devices.

As an alternative, a stack of layers comprising elongate nanostructure device structures can be intermixed with metal interconnection layer(s). As an example one elongate nanostructure device structure comprising layer (comprising n- and p-type elongate nanostructure device structures, e.g. NW-FET, on the same level) can be followed by one or more metal interconnect layer(s), on top of said metal interconnect layer(s) another layer comprising elongate nanostructure device structures can be built, followed by again one or more metal interconnect layer(s), etc.

Another example can be a nanowire FET bi-layer (Vertical CMOS) with several metal interconnect layers on top followed by another nanowire FET comprising layer, etc.

It should be clear that several combinations are possible comprising bilayers, trilayers, etc intermixed with interconnect layers. For contacting the different source, drain and gate regions, said regions can have a specific shape, defined by the mask, allowing contact regions or pads for landing of the interconnecting via. All the different source, drain and gate contacts can be individually or in combination electrically connected with the metal interconnect structure by contacting them with conducting vias (e.g. Cu, W or FUSI).

For the source regions in contact with the substrate, also (in a preferred embodiment, the source may be contacted via a source contact region on which a via is landing, as described above) the substrate itself can be used as one common source, or the structures can be built on semiconductor on insulator, e.g. Silicon On Insulator (SOI), to isolate the contact pads from bulk semiconductor material, e.g. Si, and to avoid leakage to other FET units. In the latter case, also other substrates than silicon can be used (e.g. glass, ceramics, etc)..It should be clear that in a final device comprising several vertical stacks of elongate nanostructure device structures, all proposed device concepts to obtain different design and thus different logic units can be combined.

A person skilled in the art can understand that a combination of all the presented alternatives can be implemented, e.g. more top elongate nanostructures than bottom elongate nanostructures whereby the top elongate nanostructures have different diameters than the bottom elongate nanostructures, having one or more surround gates surrounding the elongate nanostructure etc. These alternatives are also part of the present invention.

The vertical stacks of device structures of which at least one device structure is a transistor structure and at least one device structure is an elongate nanostructure device structure comprising an elongate nanostructure, are illustrated in this application to create a logic unit for application in the field of field-effect-transistor devices, but a person skilled in the art can implement the present invention in several other possible application fields wherein the at least one elongate nanostructure in the vertically stacked elongate nanostructure device structures can be used to create a channel or to provide an electrical connection.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Exemplary embodiments are illustrated in referenced figures of the drawings. It is intended that the embodiments and figures disclosed herein are to be considered illustrative rather than restrictive.
Figure 1 (PRIOR ART) shows the latch-up problem caused in a planar CMOS FET device;
Figures 2A - 2S illustrate different process steps to create a vertical stacking of nanowires for creation of a nanowire - field-effect-transistor (NW-FET) according to an embodiment of the present invention;
Figures 3A - 3L illustrate additional process steps required to create a vertical stacking of nanowires for the creation of a nanowire - field-effect-transistor (NW-FET) with use of a sacrificial gate which has to be replaced by a permanent gate, according to another embodiment of the present invention;
Figures 4A - 4I show additional process steps required to connect the vertical stacking of nanowires in a NW-FET structure with metal via contacts and a conventional Back End Of Line (copper) interconnect structure, according to a further embodiment of the present invention;
Figure 5A shows a cross-section (front-view) of a vertical stacking of a p-type NW-FET on top of an n-type NW-FET, resulting in a vertical surround gate NW-FET functioning as an inverter, according to yet another embodiment of the present invention. Figure 5B shows a top view and Figure 5C shows the electrical equivalent of the resulting structure;
Figure 6A shows a cross-section (front-view) of a vertical stacking of an n-type NW-FET structure on top of a p-type NW-FET structure, resulting in a vertical surround gate FET functioning as a follower, according to yet another embodiment of the present invention. Figure 6B shows the electrical equivalent of the resulting structure;
Figure 7 shows a cross-section (front-view) of two vertical surround gate NW-FET structures as shown in Figures 5A and 6A connected to each other in series, according to yet another embodiment of the present invention. The output of the first structure is then the input of the second structure;
Figure 8A shows a cross-section (front-view) of a vertical stacking of a p-type NW structure with two p-type nanowires on top of a single n-type NW structure, according to yet another embodiment of the present invention. The two nanowires of the p-type NW structure are both connected to the first n-type NW structure, thus creating a vertical surround gate NW-FET structure with two p-type NWs in the top section and one n-type NW in the bottom section. Figure 8B shows the top view of the structure illustrated in Figure 8A;
Figure 9 shows a cross-section (front-view) of a vertical stacking of a p-type NW structure on top of an n-type NW structure and whereby the diameters of the NW structures are different from each other, according to yet another embodiment of the present invention. In the example shown the p-type NW has a wider diameter than the n-type NW structure;
Figure 10A shows another alternative NW-FET structure according to an embodiment of the present invention, starting from two (horizontally stacked) p-type NW structures in the bottom section in connection with two vertically stacked n-type NW structures in the top section resulting in an AND-gate structure. Figure 10B shows the electrical equivalent of the structure illustrated in Figure 10A;
Figure 11A shows another alternative NW-FET structure according to an embodiment of the present invention, comprising only one NW structure. Figure 11B shows the top view of the structure illustrated in Figure 11A;
Figure 12A shows another alternative NW-FET structure according to an embodiment of the present invention, with more than one gate (surround gate) structure surrounding one individual NW-FET unit. Figure 12B shows the top view of the structure illustrated in Figure 12A;
Figure 13 shows a cross-section (front view) of a combination of a planar MOSFET (e.g an n-MOSFET) with a vertical NW-FET (e.g. p-type NW-FET), according to a further embodiment of the present invention.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

Whenever reference is made hereinafter to a particular dopant type, this is done for the ease of explanation only and is not intended to limit the invention. It is to be understood that in the examples given hereinbelow, materials and dopant types may be replaced by other suitable materials and dopant types, without changing the invention.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims. In particular, the invention will be described with reference to nanowires, however, this is not intended to limit the invention, and is only one example of an elongate nanostructure, which may include nanowires, nanorods, nanotubes and other elongated substantially cylindrical or polygonal structures having a longitudinal axis.

The present invention relates to the creation of semiconductor devices and to semiconductor devices using vertical stacks of device structures, of which at least one device structure is a transistor structure and at least one device structure is an elongate nanostructure device structure, e.g. a nanowire device structure, comprising at least one vertical elongate nanostructure, e.g. nanowire, the vertical elongate nanostructure forming a channel of the semiconductor devices. More specifically it relates to the creation of a logic unit comprising a vertical stack of device structures whereby at least one and preferably two or more vertical stacks of device structures are used as described in the preamble of the first claim. With nanowires is meant any two-dimensionally confined pieces of solid material in the form of wires, tubes, rods and similar elongated cylindrical or polygonal structures having a longitudinal axis. According to the invention, organic nanowires, such as e.g. carbon nanotubes, or inorganic nanowires, such as e.g. semiconductor (e.g. silicon) or metal (e.g platinum) nanowire may be used. With a vertical stack of device structures is meant two device structures which are vertically positioned on top of each other. With vertically is meant that, when the stack of device structures is positioned on a substrate, the substrate lying in a plane, the longitudinal axis of the device structures is positioned in a direction substantially perpendicular to the plane of the substrate. Similarly, with vertical nanowire is meant that, if the nanowire is positioned on a substrate lying in a plane, the nanowire is positioned with its longitudinal axis in a direction substantially perpendicular to the plane of the substrate.

The vertical stacks of device structures comprising at least one device structure which is a transistor structure and at least one nanowire device structure comprising at least one vertical nanowire may be applied to devices of any possible application field wherein the at least one nanowire of the nanowire device structure can be used to create a channel or to form an electrical connection. For the application in e.g. a field-effect-transistor (FET) said nanowires form the channel of the field-effect transistor.

Field-effect-transistors using nanowires as a channel or gate are known from the prior art. However, none of these prior art devices include stacks of transistor units or device structures of which at least one device structure is a transistor structure and at least one device structure is a nanowire device structure comprising at least one vertical nanowire on a substrate lying in a plane, the at least one vertical nanowire being oriented in a vertical direction, i.e. in a direction substantially perpendicular to the plane of the substrate, as is the case according to the present invention.

In a first aspect of the invention, a method is provided for the fabrication of a vertical nanowire semiconductor device comprising a vertical stack of device structures of which at least the first device structure is a transistor structure and at least the second device structure is a nanowire device structure comprising at least one vertical nanowire. Preferably, the at least one vertical nanowire may at least partly be surrounded by a gate structure. In an embodiment according to the invention, the vertical nanowire device structure may be a vertical surround-gate nanowire field-effect-transistor (nanowire FET), whereby at least one and preferably two or more vertical stacks of nanowire device structures is/are used.

According to an aspect of the invention, two different approaches will be described for the formation of the gate structure. In one approach the gate structure may be formed directly as a permanent gate and in another approach, first a sacrificial gate may be formed which will then, during further processing, be replaced by a permanent gate.

In another aspect of the invention, a vertical nanowire semiconductor device comprising a vertical stack of at least two device structures of which at least a first device structure is a transistor structure and at least a second device structure is a nanowire device structure comprising at least one vertical nanowire, is provided. Preferably, the at least one nanowire may be at least partly surrounded by a gate structure. In an embodiment according to this second aspect, the vertical nanowire semiconductor device may be a surround-gate nanowire field-effect-transistor (NW-FET) device comprising at least a first and second nanowire device structure, each nanowire device structure comprising at least one vertical nanowire, the at least one nanowire of at least one of the first and second nanowire devices being at least partly surrounded by a gate structure.

Several advantageous device structures comprising said vertical stacks of device structures will be disclosed. It will be apparent that there are numerous variations and modifications possible. Accordingly, the description should not be deemed to be limited to the description below. Again, it has to be understood that the example of a field-effect-transistor using a vertical nanowire as a channel is not limiting the invention and that the following description also applies to devices from any possible application field wherein such vertical stacked nanowires can be used to create a channel or to form an electrical connection.

The invention will mainly be described by means of a vertical surround-gate field-effect-transistor comprising at least a first and a second nanowire device structure comprising at least one vertical nanowire, but it has to be understood that this is not limiting the invention and that the invention can also be applied to other semiconductor devices having a channel or an electrical connection formed by a nanowire.

In an aspect of the invention, a processing method is provided to create a vertical nanowire semiconductor device having a substrate lying in a plane and comprising at least a first and a second device structure positioned on top of each other, wherein at least the first device structure is a transistor structure and at least the second device structures is a nanowire device structure comprising at least one nanowire positioned substantially perpendicular to the plane of the substrate. Preferably, the at least one nanowire of the nanowire device structure may at least partly be surrounded by a gate structure.

In an embodiment of the invention, the vertical nanowire semiconductor device may comprise at least a first and second nanowire device structure, positioned on top of each other. The at least first and second nanowire device structure each comprises at least one nanowire vertically positioned on top of a substrate. With vertically positioned it is meant, if the substrate is lying in a plane, that the at least one nanowire is positioned substantially perpendicular to the plane of the substrate. The at least one nanowire of at least one of the at least first and second nanowire device structure is at least partly surrounded by a gate structure, in the further description also referred to as surround gate.

Hereinafter, the method according to the invention will be illustrated for the device according to a preferred embodiment, i.e. for a vertical nanowire field-effect transistor, comprising a first and a second nanowire device structure, each nanowire device structure comprising at least one vertical nanowire. It has to be understood that this is not limiting the invention and that the method may also be applied to other vertical nanowire semiconductor devices.

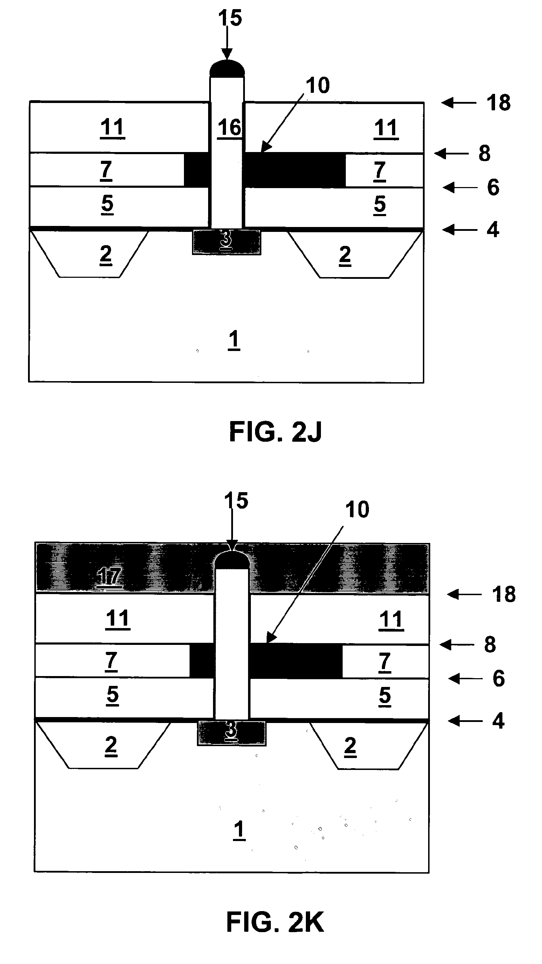

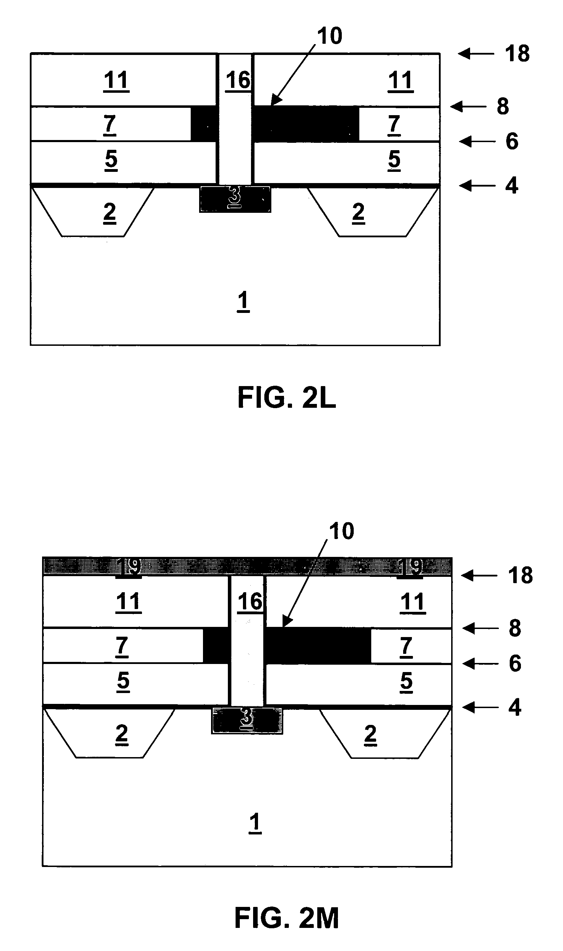

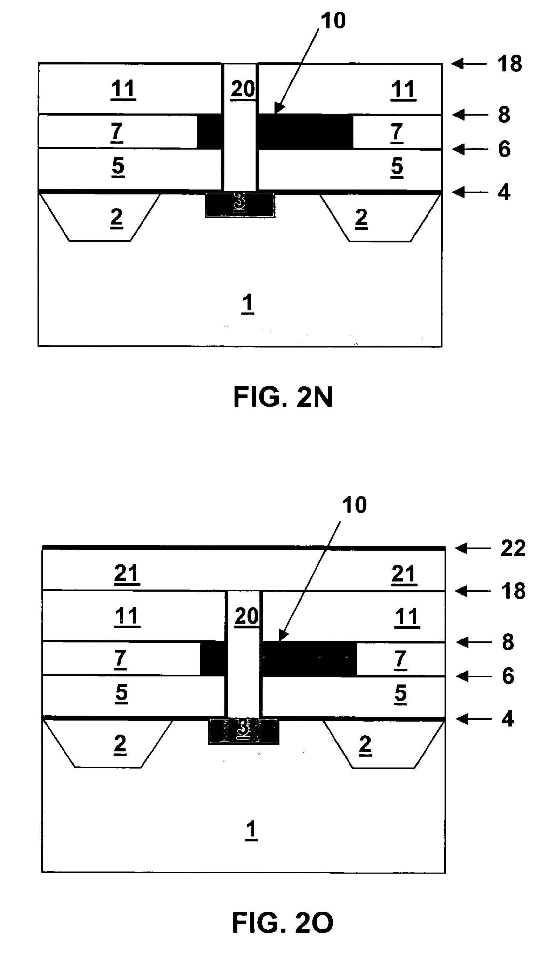

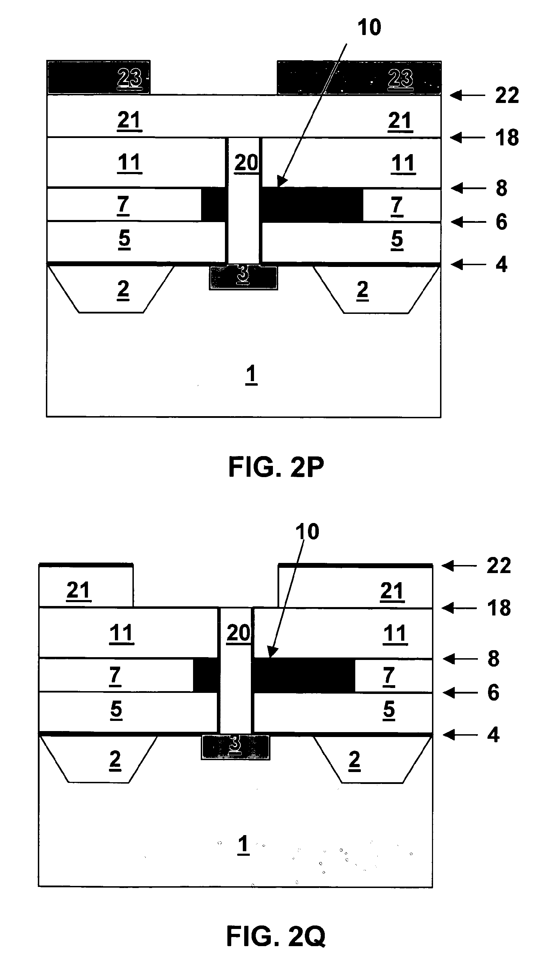

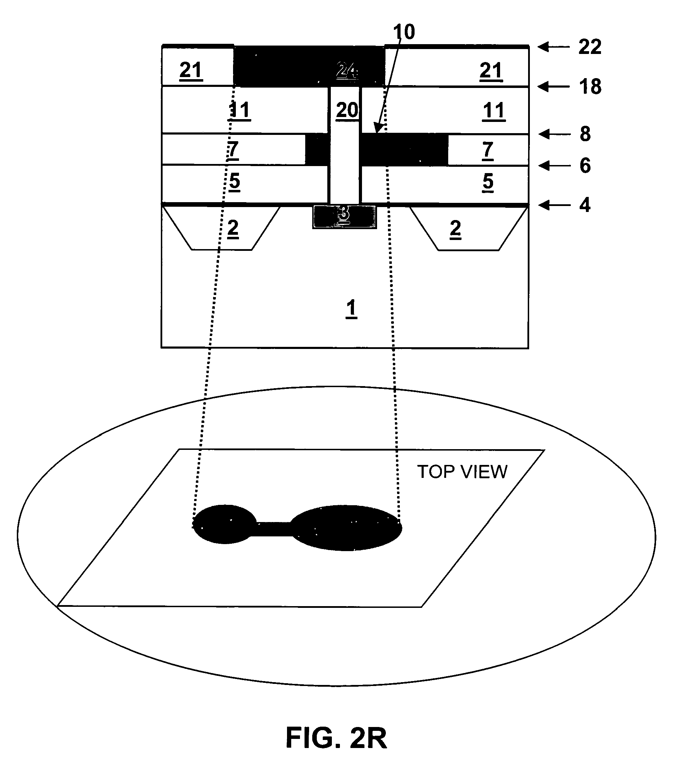

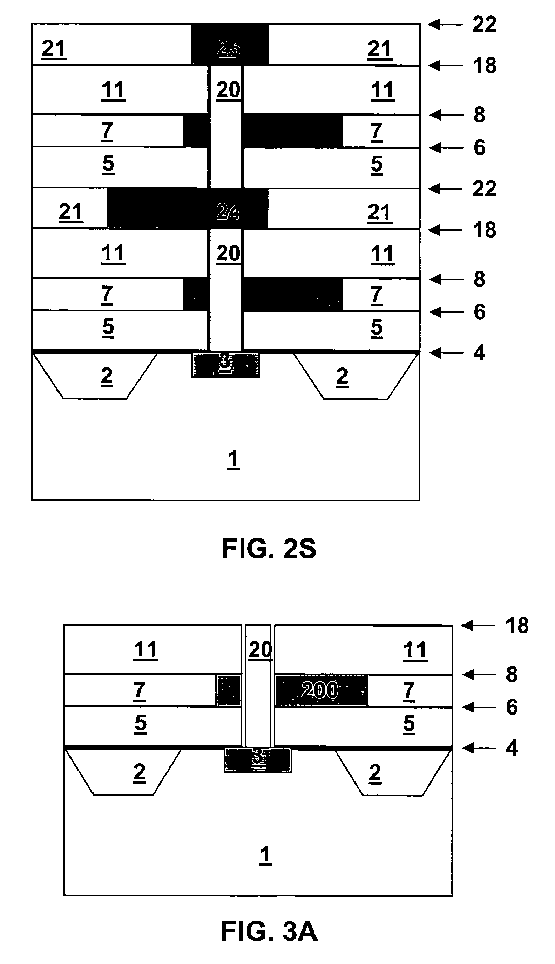

A preferred processing method is schematically illustrated in Figures 2A - 2S and will be described in detail below. It has, however, to be understood that this is only an example of a suitable method for forming a device according to the invention and that the sequence of the process steps as described hereinafter is not limiting the invention.

In a first step, illustrated in Figure 2A, a substrate 1 is provided. Preferably said substrate 1 may be a semiconductor substrate such as a silicon substrate or a silicon on insulator (SOI) substrate but any other suitable substrate can be used as well such as, for example, glass, ceramics, etc. According to an embodiment of the invention, in said substrate 1 a first contact, e.g. source contact 3 (Vₛₛ), may be created. The first contact, e.g. source contact 3, may be made of a conductive material, e.g. said first contact, e.g. source contact 3, may be a silicide containing structure (NiSi, CoSi₂, TiSi₂...), a germanide containing structure, a metal containing structure, polysilicon or a combination thereof. Also disclosed are first contacts, e.g. source contacts 3, formed of e.g. conductive oxides and even conductive polymers. In case the first contact, e.g. source contact 3, is a metal containing structure, all metals which form an ohmic contact with the material of a nanowire (NW), or in other words all metals having a comparable work function with respect to the work function of the material of the NW, are preferred metals and may be used according to the invention. Preferably the first contact, e.g. source contact 3, may be a silicide containing structure and most preferred said silicide containing structure may be a silicide containing structure surrounded by Shallow Trench Isolation (STI) units 2. The first contact, e.g. source contact 3, will be the starting point for growing the nanowire and can, at the same time, act as the catalyst for the NW growth. However, the latter is not necessary. The shape of the source contact structure 3 can be such that a contact region or pad is provided.

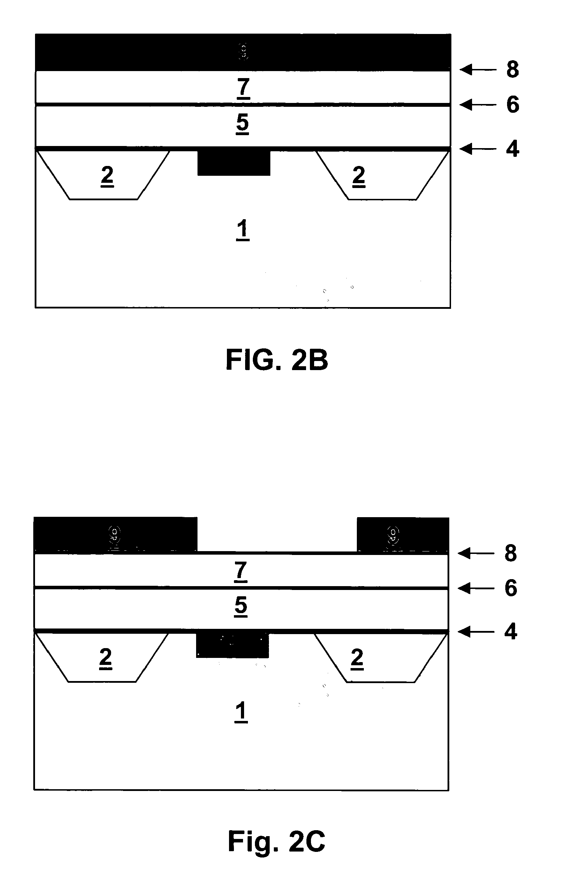

In a next step, a first stack of layers comprising a first etch stop layer 4 and a first dielectric layer 5 may be deposited onto the substrate 1 comprising said first contact, e.g. source contact 3. This is illustrated in Figure 2B. The first etch stop layer 4 may be a SiC or Si₃N₄ layer and the first dielectric layer 5 may be SiO₂ or a low-k material. Onto said first stack of layers 4, 5 a second stack of layers comprising a second etch stop layer 6, a second dielectric layer 7 and a hardmask layer 8 on top of said second dielectric layer 7 is deposited. Commonly used materials to form the hardmask layer 8 such as, for example, Si₃N₄, can be used. The first stack of layers 4, 5 and the second stack of layers 6, 7, 8 may be made of similar materials to simplify dry etching processing. In other words the dielectric materials of the first dielectric layer 5 and of the second dielectric layer 7 may be the same and etch stop layers 4 and 6 may preferably also be formed of a same material. However, according to embodiments of the invention, the first and second dielectric layers 5, 7 and/or the first and second etch stop layers 4, 6 may be formed of a different materials.

In a next step, first a gate structure at least partly surrounding the at least one nanowire of the nanowire device structure and also referred to as a surround gate, may be created in the second stack of layers 6, 7, 8. Said surround gate needs to surround the nanowire structure that will be created during further processing. Said surround gate may be, but is not necessarily, all-around the diameter of the nanowire. 10% to 95%, or 10% to 99%, or 60% to 90%, or 60% to 99% of the nanowire length may be covered by said gate structure.

The amount of the nanowire which is covered by the gate structure may, in general, be determined by a trade-off between the series resistance Rs of the nanowire and the parasitic capacitance between the gate structure and the first contact, e.g. source contact. The resistance of the part of the nanowire which is not covered by the gate structure may be determined by the nanowire doping and will to first approximation not be influenced by the gate electrode since the gate electrode does not cover the nanowire. Therefore, the longer the non-covered section, the larger the series resistance Rs of the nanowire. On the other hand, the shorter the non-covered section of the nanowire, the stronger the capacitive coupling between the gate structure electrode and the first contact, e.g. source contact. The optimal coverage is therefore a trade-off between series resistance and parasitic capacitive coupling.

How much of the nanowire needs to be covered by the gate structure, or in other words, the required degree of coverage, thus also depends on the structure and the material the nanowire is formed of and furthermore depends on the application the semiconductor device needs to be used for..

For forming the gate structure, two different approaches are possible according to embodiments of the present invention. In one approach the gate structure may be formed directly as a permanent gate made of conductive material such as e.g. poly-Si, a metal or alloy, FUSI (fully silicided metal), etc. In another approach, first a sacrificial gate may be formed (e.g. made of semiconductor material such as SiGe or Ge, or a low-k dielectric) which may then be replaced, during further processing, by a permanent gate.

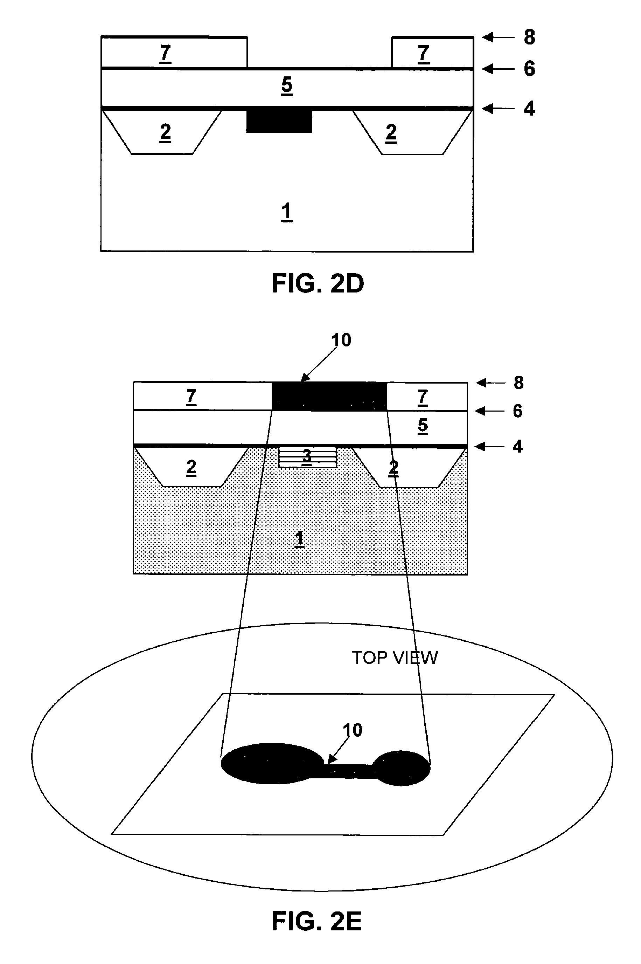

The gate structure may be created by patterning said second stack of layers 6, 7, 8 and using the second etch stop layer 6 to end the etch step. To pattern the second stack of layers 6, 7, 8, a photosensitive layer 9 may first be deposited onto said second stack of layers 6, 7, 8 (shown in Figure 2B). Commonly used photosensitive layers 9 made of at least one photoresist layer and optionally a (bottom) antireflective coating can be used. The photosensitive layer 9 may be patterned (see Figure 2C) and may then be used to etch hardmask layer 8 and second dielectric layer 7. This may for example be done by means of dry etching, e.g. Reactive Ion Etching (RIE) or may alternatively be done by means of wet etching. The etch step may, as already mentioned, be ended on the second etch stop layer 6 (see Figure 2D).

In a next step, illustrated in Figure 2E, commonly used gate materials may be used to fill up the hole thus obtained, in that way forming a gate structure 10. Examples of such gate materials are conductive materials such as poly-Si, poly-Ge, metals such as Al, W, Ta, Ti, Ru, Pd, Rh, Re, Pt and alloys thereof, metal-nitrides such as TaN and TiN, metal-silicon nitrides such as TaSiN, conductive oxides such as RuO₂ and ReO₃, fully silicided metals (FUSI) such as CoSi₂, NiSi and TiSi₂, fully germanided metals (FUGE) such as NiGe and CoGe₂ and alloys of the above with C, N, P, B, As, Sb, Bi and mixtures thereof. Optionally, a planarization step may be included to remove the overburden of gate material such that the upper level of the gate structure 10 equals the level of the hardmask layer 8 as can be seen from Figure 2E. Said planarization step can be performed by means of chemical mechanical polishing (CMP) or may be performed by means of an etch back technique using hardmask layer 8 as a stopping layer. Figure 2E shows a front and top view of the thus obtained gate structure 10. Note that the shape of the gate structure 10 is such that a contact region or pad is provided.

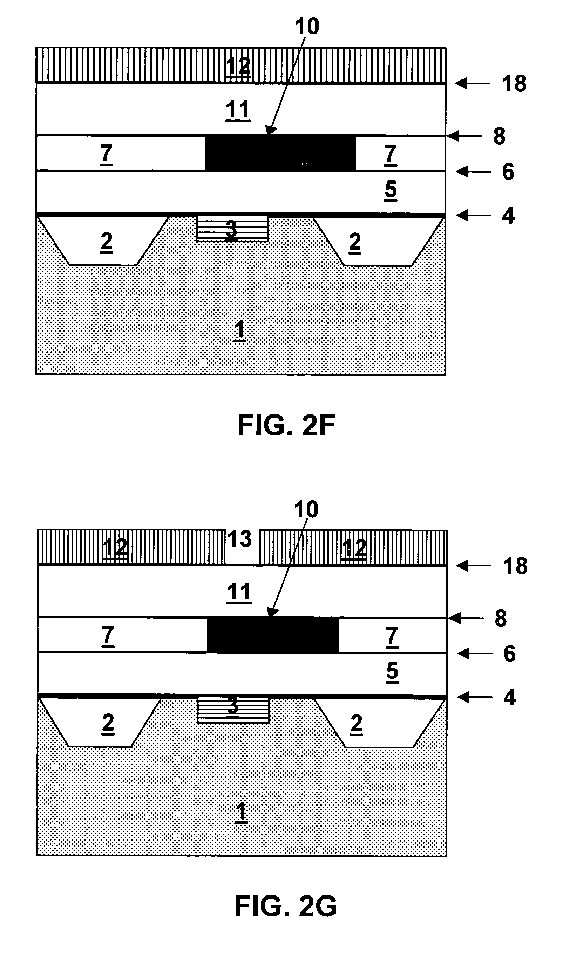

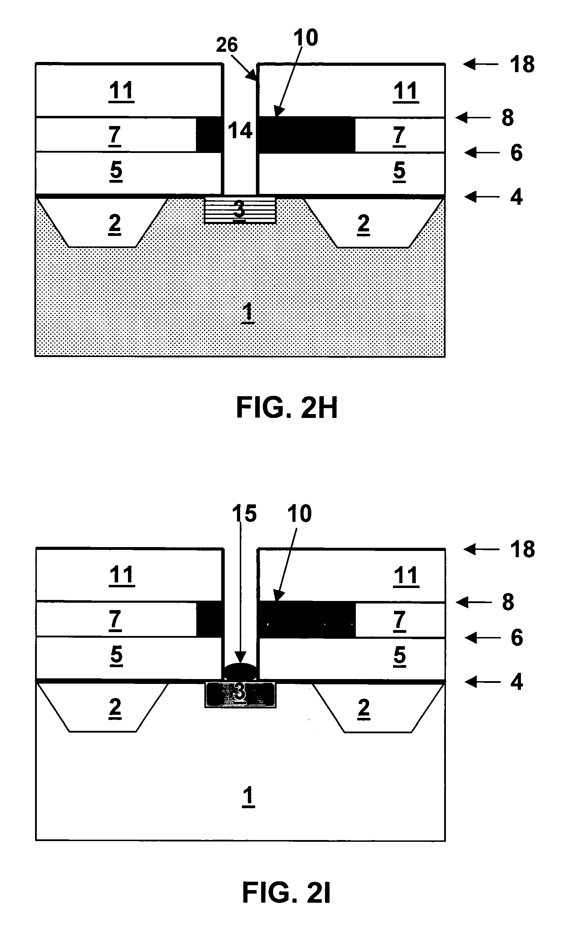

In a next step, a third stack of layers comprising a third dielectric layer 11 and a second hardmask layer 18 may then be deposited onto the previously described second stack of layers 6, 7, 8, see Figure 2F. Subsequently a hole or via 14 may be etched through the third stack of layers 11, 18, through the gate structure 10 (situated in the second stack of layers 6, 7, 8) and through the first stack of layers 4, 5 stopping on the first etch stop layer 4 on the first contact, e.g. source contact 3, as illustrated in Figure 2H. This may be done by first depositing a photosensitive layer 12 (see Figure 2F), patterning said photosensitive layer 12 for forming a hole 13 in the photosensitive layer 12 at the location of the via 14, and up to the second hardmask layer 18 (see Figure 2G) and subsequently etching the stacks of layers as indicated above, stopping on the first contact, e.g. source contact 3, as shown in Figure 2H, in that way forming hole or via 14.

In said hole or via 14 first a thin gate insulating layer 26, such as a gate oxide layer, may be deposited, acting as an insulator. Examples of oxides which may be used to form said thin gate insulating layer 26 are TEOS-oxide, SiO₂, SiON, high-k dielectrics such as HfO₂, Ta₂O₅ and/or combinations thereof.

An additional anisotropical or directional back etch step may be done to remove that part of the gate insulating layer 26 that covers the first contact, e.g. source contact 3. Instead of depositing a gate insulating layer 26 in the hole or via 14, alternatively the material of the gate structure 10, e.g. metal, can be oxidized and the so-formed thin native oxide may then be used as gate insulating material. In this case, the oxide is formed selectively onto the material of the gate structure 10 only. Examples of gate materials which give appropriate gate oxides as gate insulating materials are Si (SiO₂), Al (Al₂O₃), Ta (Ta₂O₅), Ti (TiO₂) etc.

In a next step, a nanowire 16 may be grown in the hole or via 14. Preferably the grown nanowires 16 are making tight contact with the created gate structure 10 and thin gate insulating layer 26. One way of growing a nanowire in the hole 14 may be by first depositing a catalyst particle 15 at the bottom of said via or hole 14 to start the growth process of the nanowire 16 (see Figure 2I). In other embodiments, the via 14 may first be partially filled with nanowire material by e.g. electrochemical deposition using the substrate 1 as an electrode. In still other embodiments, the nanowire may directly be deposited in the hole or via 14.

Whether or not catalyst particles 15 are required to grow the nanowire 16 in the hole or via 14 depends on the material the nanowire 16 is formed of and on the material the nanowire 16 is grown on, in the example given the material of first etch stop layer 4. For example, if the first etch stop layer 4 is formed of NiSi and the nanowire is formed of Si, no catalyst particles 15 are necessary because NiSi is a catalyst for Si nanowire growth. Furthermore, the requirement of catalyst particles 15 also depends on the technique used to form the nanowire 16 in the hole or via 14.

The nanowires 16 may preferably be formed by means of a VLS (Vapour-Liquid-Solid) process, but also any other suitable technique known by a person skilled in the art may be used to form the nanowires 16 according to the invention. For example, the nanowires 16 may be grown using techniques such as, for example, CVD (Chemical Vapour Deposition), MOCVD (Metal Organic Chemical Vapour Deposition), or PECVD (plasma enhanced chemical vapour deposition) processes. Alternatively, also PLD (Pulsed Laser Deposition), ECD (Electrochemical Deposition), e-beam or MBE (Molecular Beam Epitaxy) processes may be used to grow the nanowires 16.

The nanowires 16 may be organic (e.g. carbon nanotube) or inorganic nanowires (semiconducting materials, metals and alloys, silicides). Specific examples of nanowire materials that can be used to grow the nanowires 16 in the via 14 are group IV materials such as Si, Ge, C and binary compounds thereof, group III/V materials such as In, Ga, As, Sb, Al, P, B, N and binary, tertiary and quaternary compounds thereof and group II/VI materials such as Cd, Zn, S, Se, Te, O and binary, tertiary and quaternary compounds thereof. Other examples of nanowire materials that can be used with the present invention are silicides, germanides, metals and alloys.

Optionally, but this is not a requirement of the invention, the nanowires 16 may be doped during the growth process to obtain n-type or p-type nanowires 20 and/or to create nanowires comprising regions of high doping and/or low doping and/or no doping. Alternatively, the doping of the nanowires 16 may be performed after growth of the nanowires 16 by means of an additional doping step. The doping may be uniform, gradual or discontinuous (e.g. highly doped-lowly doped-highly doped regions, or n-doped regions altered with p-doped regions,...).

On a full wafer scale, many nanowires 16 may be grown simultaneously and there can be a difference in length between these nanowires 16. Preferably the length of the nanowires 16, without taking the catalyst particle 15 into account, equals the distance between the first contact, e.g. source contact 3, or the first etch stop layer 4 present on the first contact, e.g. source contact 3, and the second hardmask layer 18 but some nanowires 16 will be longer (as shown in Figure 2J). The final dimensions of said nanowires 16 may preferably be in the range of 0.2 to 500 nm, preferably 1 to 500 nm, for the diameter of the nanowire 16 and more preferred in the range of 5 to 200 nm for the diameter with a preferred length of 10 nm up to 2 µm, preferably 20 nm up to 2 µm and more preferred a length of 50 nm up to 500 nm or most preferred up to 1 µm.

To obtain nanowires 16 all having the same length (with the top of the nanowires 16 equal to hardmask 18 top level) and to remove the catalyst particle 15 (if needed) a planarization step may be required. To facilitate the planarization, first a planarizing layer 17 may be deposited onto the second hardmask layer 18 (see Figure 2 K). Preferably said planarizing layer 17 may be a dielectric material such as SiO₂ and preferably the planarizing technique used may be Chemical Mechanical Planarization (CMP) using the second hardmask layer 18 as a stopping layer. The result after the planarizing step is illustrated in Figure 2L, all nanowires 16 having a length from the first contact, e.g. source contact 3 or first etch stop layer 4 up to the top level of the hardmask 18.

As already discussed, in case the nanowires 16 are not doped during the growth process, an extra doping step may be advantageous. For example, implantation of dopant elements followed by activation of the dopant elements by e.g. annealing can be applied to achieve n-type or p-type nanowires 20. Alternatively, a layer, which is also referred to as dopant layer 19 and which comprises dopant elements can be deposited onto the planarized surface (as shown in Figure 2M) or a dopant metal can be selectively deposited, e.g. with electrochemical deposition, onto the nanowire areas (not shown). An anneal step may then be applied so as to incorporate the dopant into the nanowire 16, resulting in an n-type or p-type nanowire 20 being obtained (Figure 2N).

A similar approach can be used to make, for example, a highly doped region at the end of the nanowire 16 only. Figure 2N shows the resulting structure comprising the doped nanowire 20 after anneal and removal (e.g. by chemical mechanical polishing or chemical stripping) of the dopant layer 19.

As shown in Figure 2O a fourth stack of layers is then deposited onto the already obtained structure, the fourth stack comprising a fourth dielectric layer 21 and a third hardmask layer 22. In said fourth stack of layers 21, 22, a pattern needs to be created to form a second contact, e.g. an output contact 24, which may be a conductive structure such as e.g. a metal containing structure, a silicide containing structure, a germanide containing structure, polysilicon or a combination thereof. The second contact, e.g. output contact 24 may thus be formed of materials which may be similar to the materials used to form the previously described first contact, e.g. source contact 3. To form the second contact, e.g. output contact 24, the fourth stack of layer 21, 22 may be patterned. Therefore, a photosensitive layer 23 is first deposited onto said fourth stack of layers 21, 22. Commonly used photosensitive layers 23 made of at least one photoresist layer and optionally a (bottom) antireflective coating can be used for this purpose. The photosensitive layer 23 may then be patterned, as shown in Figure 2P, and then the third hardmask layer 22 and subsequently the fourth dielectric layer 21 may be etched. The etch step may be stopped by using the second hardmask layer 18 or the nanowire material as an etch stop layer. The etch step may be performed by means of, for example, dry etching, e.g. RIE. Note that the shape of the second contact, e.g. output contact 24 should be such that a contact can be made afterwards. The etching results in a patterned fourth stack of layers comprising a hole suitable for being filled with a conductive material such as a metal, silicide or germanide containing material, polysilicon, or a combination thereof, as shown in Figure 2Q. The resulting structure after filling the hole with a conductive material such as a metal, silicide or germanide containing material, polysilicon or a combination thereof, is shown in Figure 2R. In the further description, this structure as described hereinabove will be referred to as a first nanowire device structure, in the example given a nanowire field-effect-transistor (NW-FET) or nanowire FET structure. If a doped, i.e. a p-type (or n-type) nanowire 20 is present, the resulting structure will act as a p-type (or n-type) nanowire-FET structure with a surround gate structure 10.

The whole processing sequence to obtain a first nanowire device structure, in the example given nanowire-FET structure, as described in the previous steps can be repeated to build a second nanowire FET structure on top of the first nanowire FET structure starting on the second contact, e.g. output contact 24. In case the first nanowire FET structure is a p-type nanowire FET structure, the second nanowire FET structure may preferably be an n-type nanowire FET structure. The material the gate structure 10 is formed of can be different for n-type and p-type nanowires 20 (especially valid for metal gates). In case a metal containing first contact, e.g. source contact 3 and second contact, e.g. output contact 24 is used, also here the choice of metal (alloys) may be different for n-type and p- type (ohmic contact).

The final structure comprising a first nanowire device, in the example given a p-type FET structure, and a second nanowire device, in the example given an n-type nanowire FET structure formed by the method as described in this embodiment, is shown in Figure 2S. The previously described processing sequence can be combined, repeated and altered to create the different device structures as described in the second section of this disclosure. To make, for example, n-type and p-type nanowires 20 at a same level, i.e. in a same device structure or nanowire device structure, either patterning steps (Figures 2G-2H) and subsequent nanowire growth steps (Figure 2I-2J) need to be repeated twice: once for growth of n-type nanowires and once for growth of p-type nanowires. When starting from undoped nanowires, also doping steps (Figure 2M) need to be performed twice: once selectively on n-type nanowires, and once selectively on p-type nanowires, both doping steps making use of suitable masks. In the latter case, patterning of the dopant layers 19 may be necessary. Note as well, that a similar sequential growth of nanowires can be repeated several times, and can be used not only for different doping types and profiles but even for different nanowire materials in a same stack of layers.

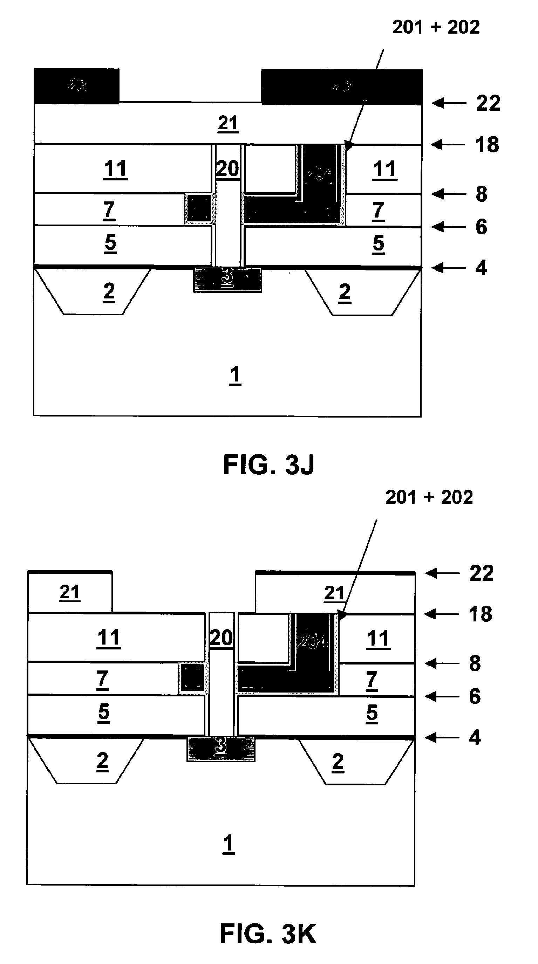

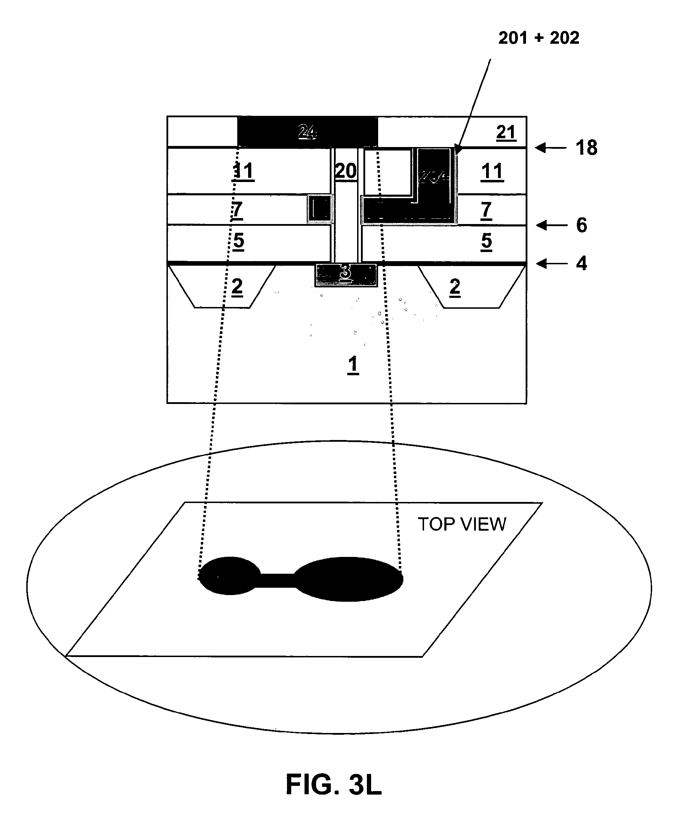

An alternative but also preferred approach of the above-described process for forming a nanowire device structure comprising at least one vertical nanowire, the nanowire being at least partly surrounded by a gate structure 10, will be illustrated hereinafter in a further embodiment of the current aspect of the present invention. In this approach, first a sacrificial surround gate 200 may be formed which will, during further processing, be replaced by a permanent gate structure 204 after finalizing the nanowire growth, planarization and doping. Examples of suitable materials which may be used for forming the sacrificial surround gate 200 are e.g. Ge, SiGe or low-k materials such as, for example, porous silicon based dielectrics. In this case the gate insulating layer 26 may be formed after the nanowire growth step and more particular after the removal of the sacrificial gate material. This approach results in a tight contact between the gate structure 204, gate insulating layer 26 and nanowire 20, and is particularly interesting in those cases where the nanowire diameter turns out slightly smaller than the via hole 14. The processing sequence is shown in Figures 3A to 3L.

The sacrificial surround gate 200 (see Figure 3A) may be formed in the same way as described above and illustrated in Figures 2A to 2E for the gate structure 10, except for the material used for this sacrificial surround gate 200 (see above). Furthermore, a nanowire device structure, e.g. nanowire FET structure, as illustrated in Figure 3A comprising a doped nanowire 20 surrounded by the sacrificial surround gate 200 may also be formed as described above (Figures 2F to 2L).

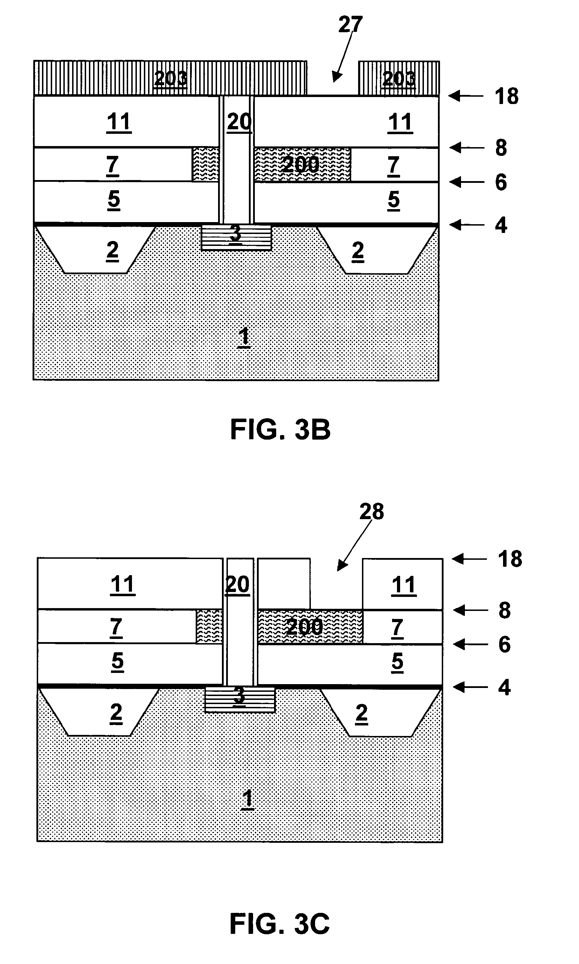

Further processing may be done by e.g. etching a via 28 in the third dielectric layer 11 in order to set free a part of the sacrificial surround gate 200 at the top. Therefore, a photosensitive layer 203 may be deposited onto the second hardmask layer 18. The photosensitive layer 203 may be patterned by forming a hole 27 in said layer 203 (see Figure 3B). These holes 27 may then be used to remove part of the third dielectric layer 11 in order to set free part of the sacrificial gate structure 200 as illustrated in Figure 3C.

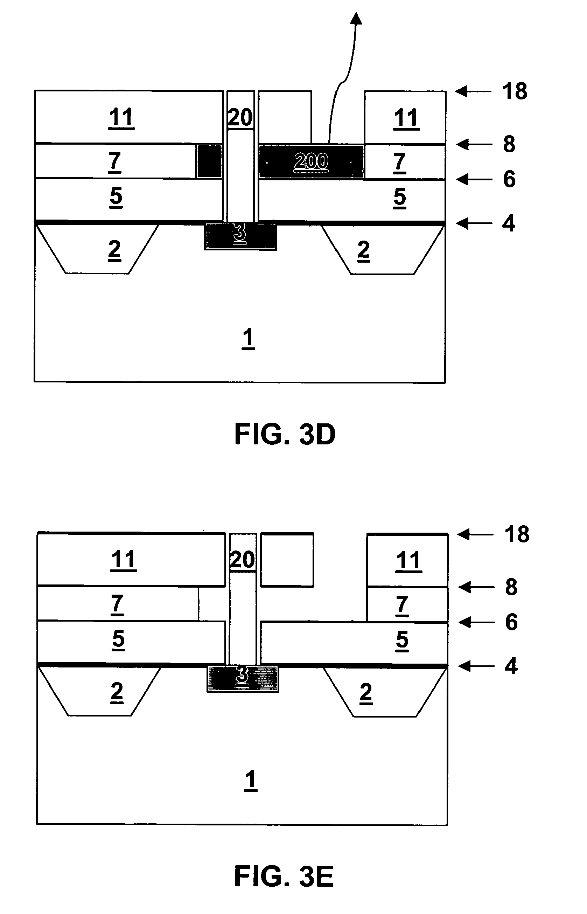

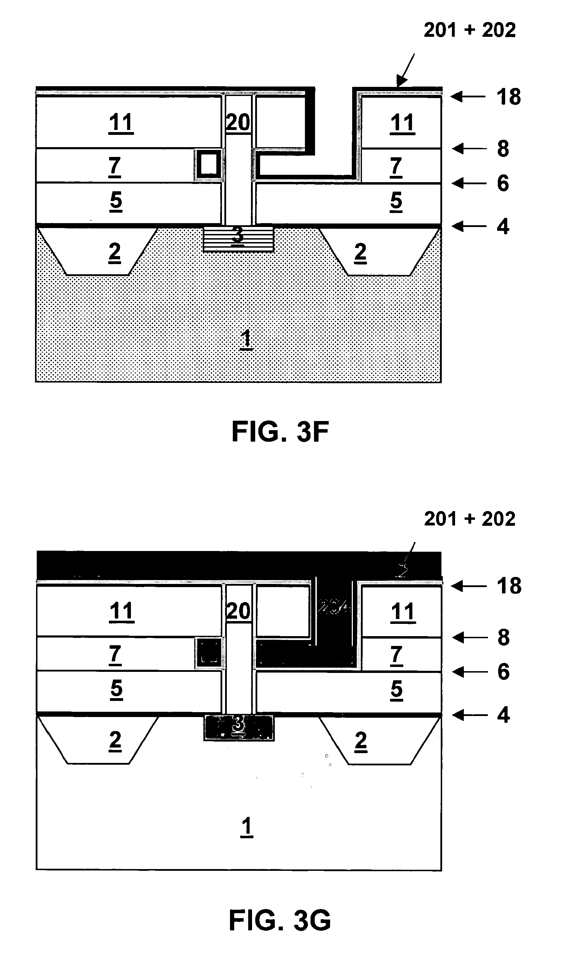

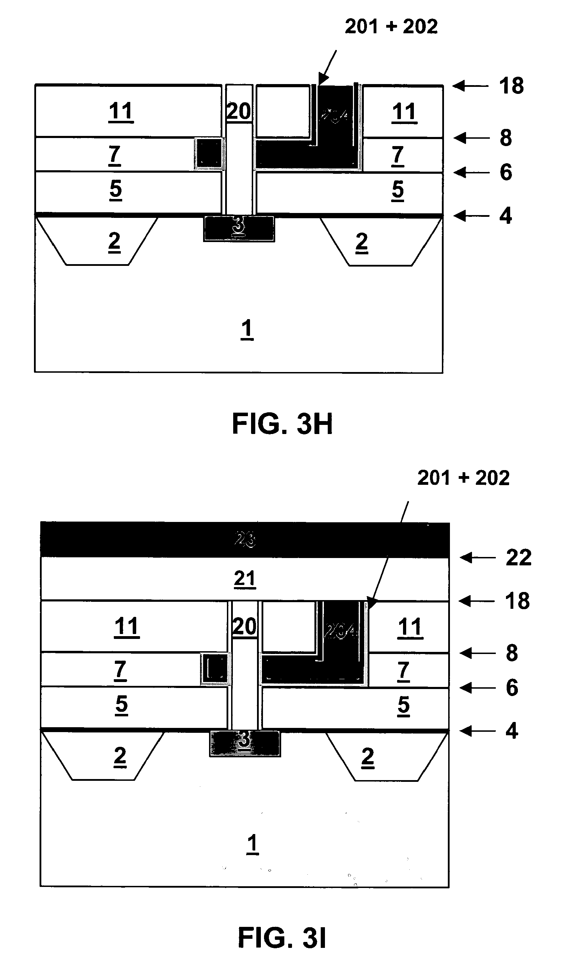

Subsequently, an etch step, for example a chemical etch (removal) step, may be applied to remove the sacrificial material or, in other words, to remove the sacrificial gate structure 200 (as shown in Figure 3D and 3E). Then, a thin layer 201 of gate insulating material, e.g. gate oxide, may be deposited conformal (e.g. by Atomic Layer Deposition or Chemical Vapor Deposition processes) to the sidewalls of the 'hollow' gate structure and the exposed nanowire 20. A permanent gate material may then be deposited into the hollow gate structure; preferably the deposition of the permanent gate material may be such that tight contact is made to the nanowire 20. Preferably, before the hollow gate structure is fully filled with permanent gate material, first a conformal layer 202 made of gate material such as e.g. poly-Si, FUSI or a metal may be deposited onto said first deposited gate insulating layer 201, e.g. gate oxide (see Figure 3F). After deposition of gate insulating layer 201 and conformal layer 202 the gate structure may be filled up with a filling material (see Figure 3G) followed by e.g. a CMP step to planarize the surface to form the permanent gate structure 204 (Figure 3H). The filling material can be any suitable conductive material deposited by e.g. physical or chemical vapor deposition or plating. In the latter case a conductive seed, and possibly a protective barrier layer, may be deposited on top of the gate material layer first. The filling material can also be a non-conductive material such as, for example, a silicate glass (TEOS) fill.

Further processing as shown in Figure 3I to 3L is to create a second contact, e.g. output contact 24, which may be formed of a conductive structure, e.g. a silicide containing structure, a germanide containing structure, a metal containing structure, polysilicon or a combination thereof, and which may be similar to previously described process steps in the previous section, same reference numerals referring to analogous device regions and corresponding process steps.

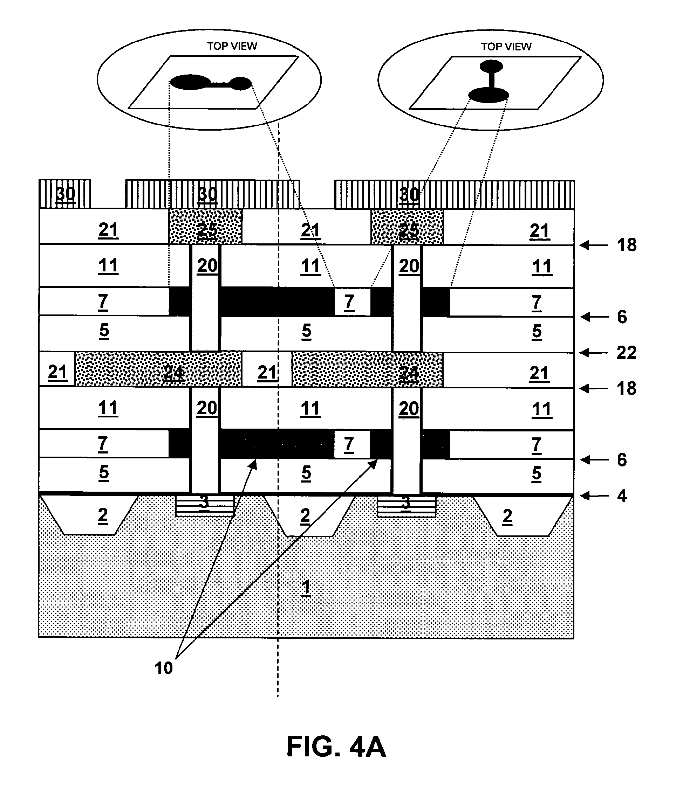

Figures 4A to 4I describe the processing sequence to connect the previously described nanowire device structures, in the examples given nanowire FET structures or vertical surround-gate field-effect-transistor active device structures (also referred to as Front End of Line or FEOL), to the interconnect structure in the Back End Of Line (BEOL). Starting from Figure 2S, which in the further description will be referred to as an example of a final FEOL structure, a deep via may be created to form a conductive contact, e.g. metal contact, during further processing. Said deep via conductive contact, e.g. metal contact, is needed to connect the vertically stacked nanowire device structures to each other to form a logic unit and then to connect the resulting logic units to the BEOL interconnect structures to have the separate logic units connected for logic operations. Note that, for simplicity, the vias, which connect the first contacts, e.g. source contacts 3 to the BEOL interconnect structures, are not shown in Figures 4A to 4I.

Figure 4A starts (as an example) from a FEOL structure comprising two vertical surround-gate field-effect-transistors (FET), each individual FET comprising two vertically stacked nanowire FET structures (a p-type NW-FET and n-type NW-FET) with a first contact - source contact 3, a second contact - output contact 24, a third contact - drain contact 25, two surround gate structures 10 and two doped nanowires 20, i.e. a p-type and an n-type nanowire. The dashed line in Figure 4A indicates an imaginary separation between the two FET devices.

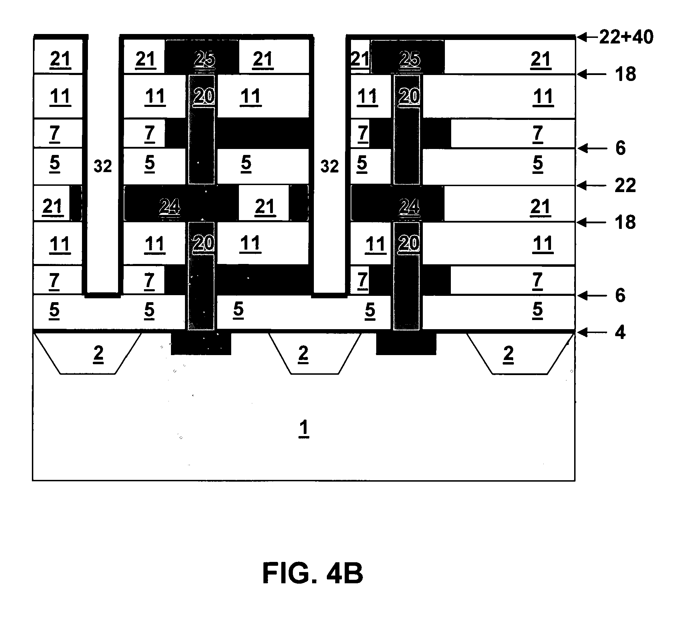

In order to create a deep via into the structure, first a photosensitive layer 30 may be deposited onto the previously described structure. A via pattern needs to be transferred to the structure. This may be done by any suitable technique known by a person skilled in the art. Next, by means of e.g. dry or reactive ion etching, vias 32 may be formed into the different stacks of layers stopping on the last contacting layer or region, i.e. in the example given on the second etch stop layer 6, as illustrated in Figure 4B. Note that in Figures 4A-4I, the vias 32 all have the same depth, but if necessary for a particular application, vias 32 with different depth can be created landing on the different contact pads (e.g. on source contacts 3 or output contacts 4).

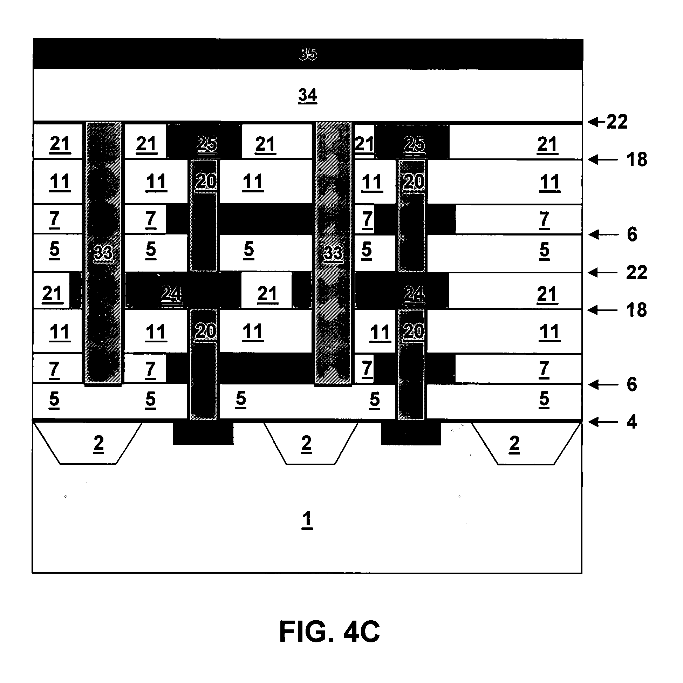

As shown in Figure 4B and 4C the vias 32, which make contact with the second contact, e.g. output contact 24, of the NW-FET structure, and gate structures 10, may be filled with a conductive material to create filled vias 33. Examples of suitable conductive materials for filling the vias 32 and which may be used with the present invention are metals such as aluminum, copper, tungsten, noble metals such as ruthenium, platinum, or metal silicides and germanides. Deposition processes such as, for example, conventional physical or chemical vapor deposition and plating can be used to fill the vias 32. If necessary, or optionally, a seed layer and/or barrier layer and/or adhesion layer 40 may be deposited first. A seed layer may be advantageous if filling the vias 32 is performed by plating. For example, if the vias 32 are filled with Cu, a Cu seed layer may be required. A barrier layer may be advantageous for preventing the material the vias 32 are filled with from diffusing into the material of the second contact, e.g. output contact 24. An adhesion layer may be advantageous if the bottom of the vias 32 is formed of a material on which the adhesion of the material the vias 32 are filled with shows a low or no adhesion. For example, if the vias 32 are filled with Cu and the bottom of the vias 32 are formed of TaN, a Ta layer first has to be deposited onto the bottom of the vias 32 before Cu can be used to fill the vias 32. The use of these different layers is similar to the use of these layers in damascene processing.

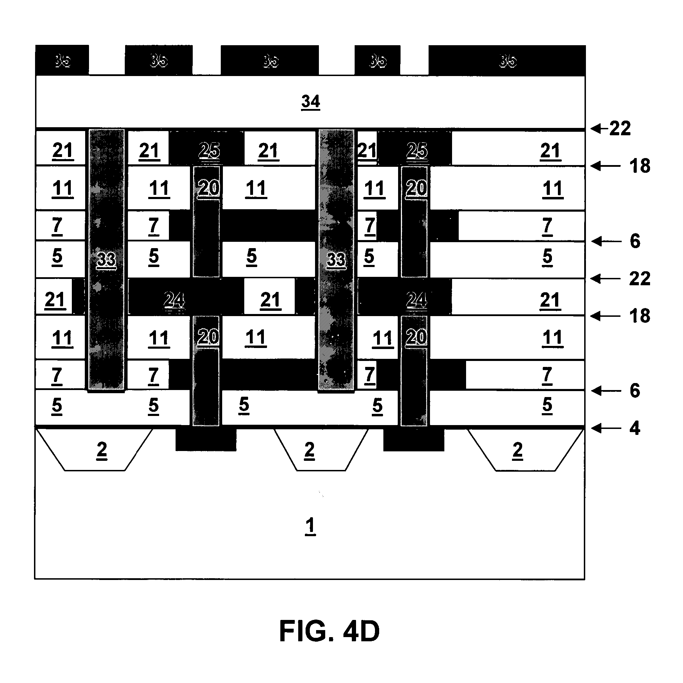

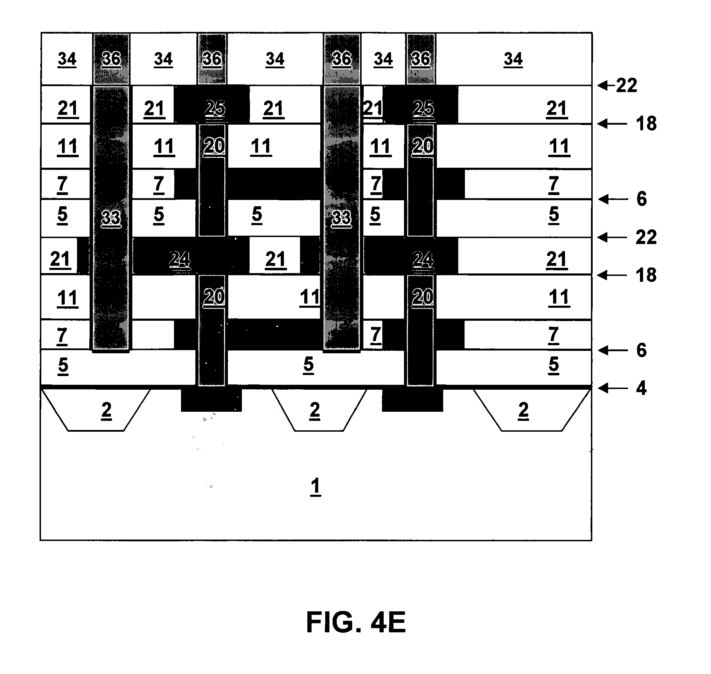

The excess conductive material of the filled vias 33 and the seed and/or barrier layer and/or adhesion layer 40 may then be removed from the planar top surface by, for example, chemical mechanical polishing (CMP) or etching. The third hardmask layer 22 may thereby act as a stopping layer. Subsequently, a dielectric layer 34 and a photosensitive layer 35 may be deposited (see Figure 4C). Next, a pattern is formed in the photosensitive layer 35 (see Figure 4D). This may be done by any suitable technique known by a person skilled in the art. The pattern in the photosensitive layer 35 may then be used to etch the dielectric layer 34, in that way forming vias in the dielectric layer 34 (not shown). The vias in the dielectric layer 34 may then be filled to create intermediate metal contacts 36 in the dielectric layer 34 - see Figure 4E - that make contact with the deep filled vias 33 and the third contact, e.g. drain contact 25, which may e.g. be a silicide containing structure, a germanide containing structure, a metal containing structure, polysilicon or a combination thereof. The material used to fill the vias to form the metal contacts 36 may be conductive materials such as, for example, metals such as Al, Cu, W or noble metals such as Ru and Pt, with optionally a barrier layer and/or conductive seed layer and/or adhesion layer. The structure obtained after the above steps is shown in Figure 4E.

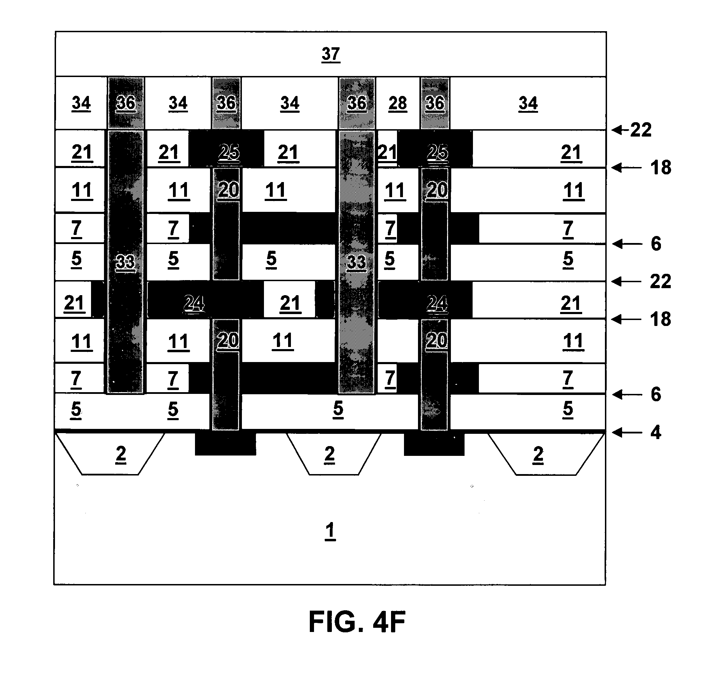

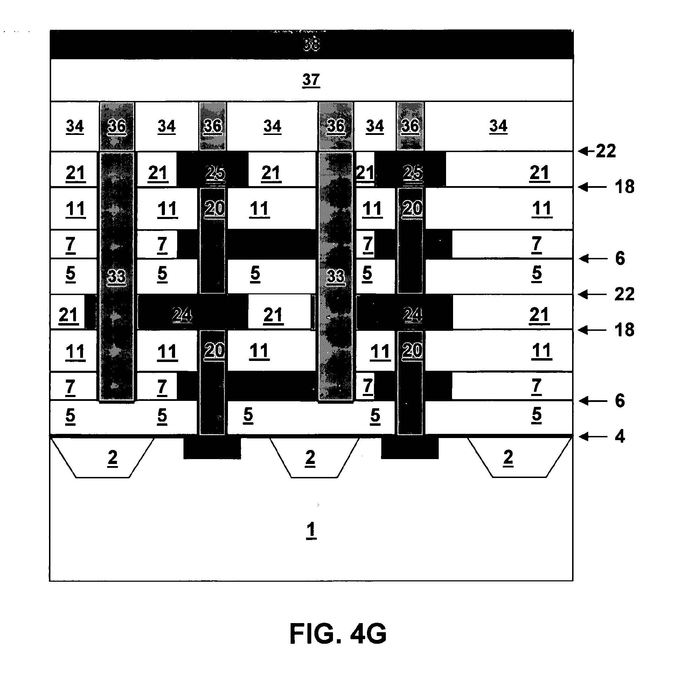

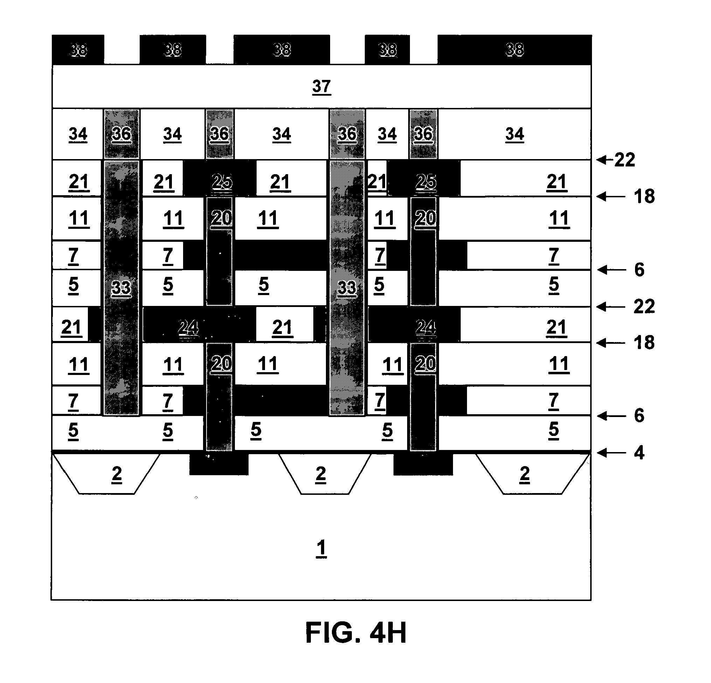

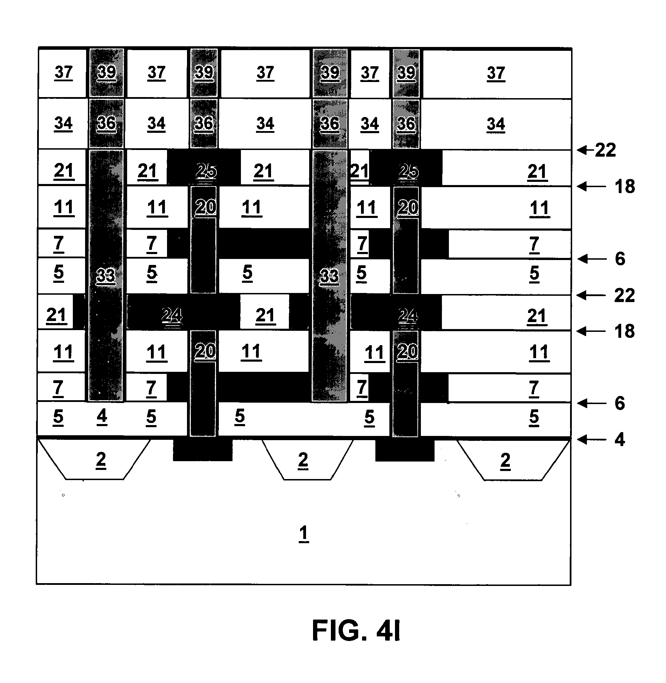

Finally a BEOL interconnect structure with metal lines and vias may be formed similar to conventional CMOS processing. To create these interconnect structures a dielectric layer 37 (see Figure 4F) and a photosensitive layer 38 (see Figure 4G) may be deposited on top of the structure as illustrated in Figure 4E. The photosensitive layer 38 may then be patterned by providing it with a pattern of lines and holes (see Figure 4H). The pattern in the photosensitive layer 38 may then be used to form trenches (not shown) in the dielectric layer 37, for example by means of an etching step. The trenches may then be filled to create metal interconnects 39 in the dielectric layer 37. The final structure obtained so far is illustrated in Figure 4I. Further processing may be performed similar to the conventional BEOL processing. Note that when opted for Cu as the metal of choice for the deep vias 33, the intermediate metal contacts 36 in dielectric layer 34 may not be necessary and the Cu interconnect level may be put down immediately on top of the deep vias 33 and dielectric layer 21.

According to another embodiment of the invention, the method may also be used to form vertical nanowire semiconductor devices different from the vertical surround-gate field-effect transistor as described above. For example, the method may also be used to form a vertical nanowire semiconductor device comprising a first nanowire device structure comprising at least one nanowire 16 that is at least partly surrounded by a gate structure 10. On top of the first nanowire device structure, in the example given a nanowire FET structure, instead of another nanowire FET structure as was the case in the examples given above, a second nanowire device structure may be positioned comprising at least one nanowire 16 formed of a conductive material such as a silicide, a germanide, a metal or metal alloy. In this embodiment, the at least one nanowire 16 of the second nanowire device structure is not surrounded by a gate structure 10.

In an alternative embodiment, the method may be used to form a vertical nanowire semiconductor device comprising a first nanowire device structure which may comprise at least one nanowire 16 formed of a conductive material such as a silicide, a germanide, a metal or a metal alloy which is not surrounded by a gate structure 10. On top of the first nanowire device structure, a second nanowire device structure may be positioned, comprising at least one nanowire 16 which is at least partly surrounded by a gate structure 10.

In further embodiments, the method may be used to form structures as described in the above-described embodiments which may furthermore comprise at least one further nanowire device structure positioned on top of the described first and second nanowire device structures, the at least one further nanowire device structure comprising at least one nanowire 16 which may or may not be at least partly surrounded by a gate structure 10. The method according to the invention may be used to form vertical nanowire semiconductor devices comprising as many levels as required to form a device suitable for different applications.

In still further embodiments, the method may be used to form vertical nanowire semiconductor devices comprising a first and a second device structure positioned on top of each other. According to these further embodiments he first device structure may be a planar transistor device structure, such as e.g. a planar MOSFET or a planar double-gate MOSFET structure (e.g. a finFET) or tri-gate MOSFET structure. The second device structure may be a nanowire device structure comprising at least one vertical nanowire 16 which may or may not, depending on the application, be at least partly surrounded by a gate structure 10. The vertical nanowire semiconductor device according to these further embodiments may furthermore comprise additional device structures positioned on top of or below the first and second device structure.

It has to be understood that the nanowires 16 in the nanowire device structures of these further embodiments may all have the same properties as the nanowires 16 described in the earlier embodiments. The nanowires may have a diameter between 0.2 and 500 nm, preferably between 1 and 500 nm, and most preferred the diameter of the at least one nanowire may be between 5 and 200 nm. The length of the nanowires 16 may be between 10 nm and 2 µm, preferably between 20 nm and 2 µm, and most preferred the length of the nanowires may be between 50 nm and 1 µm. Furthermore, the different nanowire device structures may comprise nanowires 16 having a same or a different diameter, may comprise a same or a different number of nanowires 16 and may comprise a horizontal stack of nanowires 16. Moreover, gate structures 10 at least partly surrounding the nanowires of different nanowire device structures may be connected to each other by means of a conductive structure.

In an aspect of the invention, a vertical nanowire semiconductor device is provided. The vertical nanowire semiconductor device comprises at least a first and a second device structure positioned on top of each other. According to the present invention, at least the first device structure is a transistor structure and at least the second device structure is a nanowire device structure comprising at least one vertical nanowire. With vertical nanowire is meant, when the nanowire is positioned on a substrate lying in a plane, the nanowire is positioned substantially perpendicular to the plane of the substrate. Preferably, the at least one nanowire of the nanowire device substrate may at least partly be surrounded by a gate structure.

According to an embodiment of the present invention, the vertical nanowire semiconductor device may be a vertical surround-gate field-effect-transistor comprising at least a first and a second nanowire device structure being positioned on top of each other onto a substrate. The at least first and second nanowire device structures comprise at least one nanowire which is, if the substrate is lying in a plane, positioned in a direction substantially perpendicular to the plane of the substrate. The at least one nanowire of at least one of the first and second nanowire device structures is at least partly surrounded by a gate structure. The device will in the further description mainly be described by means of a vertical surround-gate field-effect-transistor. Again, it has to be understood that this is not limiting the invention and that the invention may be applied to devices of any possible application field wherein these vertical stacked nanowires can be used to create a channel or to form an electrical connection. For the application in e.g. a field-effect-transistor (FET) said nanowires form the channel of the field-effect transistor.
Below, several possible device structures which may be implemented by the vertical nanowire semiconductor device, e.g. the vertical surround gate nanowire field-effect transistor, or according to the present invention will be briefly shown and described. In each of the presented device structures, the vertical stacking of nanowires can be achieved by the processing method disclosed by this invention and described in detail with respect to the previous aspect. It has to be understood that all materials described with respect to the previous aspect for forming particular parts of the semiconductor device according to the invention are also considered to be disclosed in the devices described below, although they are not specified here anymore. However, several alternatives to the disclosed processing method are possible and thus the proposed device structures described below are not limited to the processing method described above. Again, it has to be understood that the invention is not limited to the vertical surround-gate field-effect transistor but that any semiconductor device comprising a channel or an electrical connection formed by a nanowire and comprising at least two nanowire device structures positioned on top of each other is disclosed by this invention.

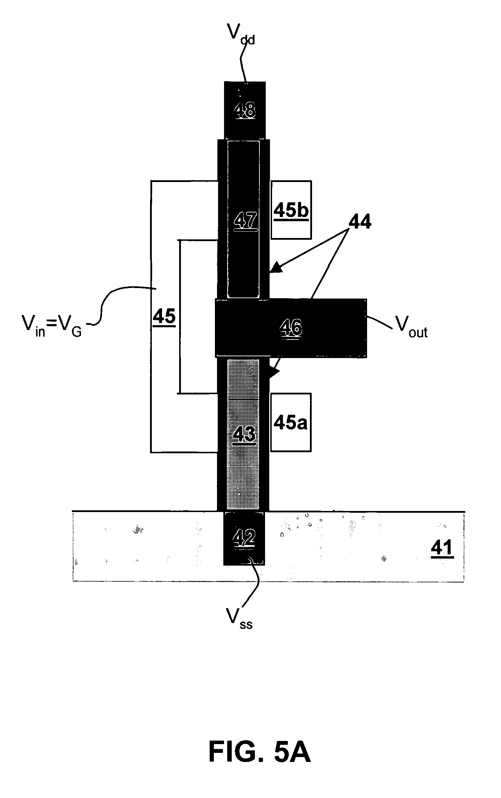

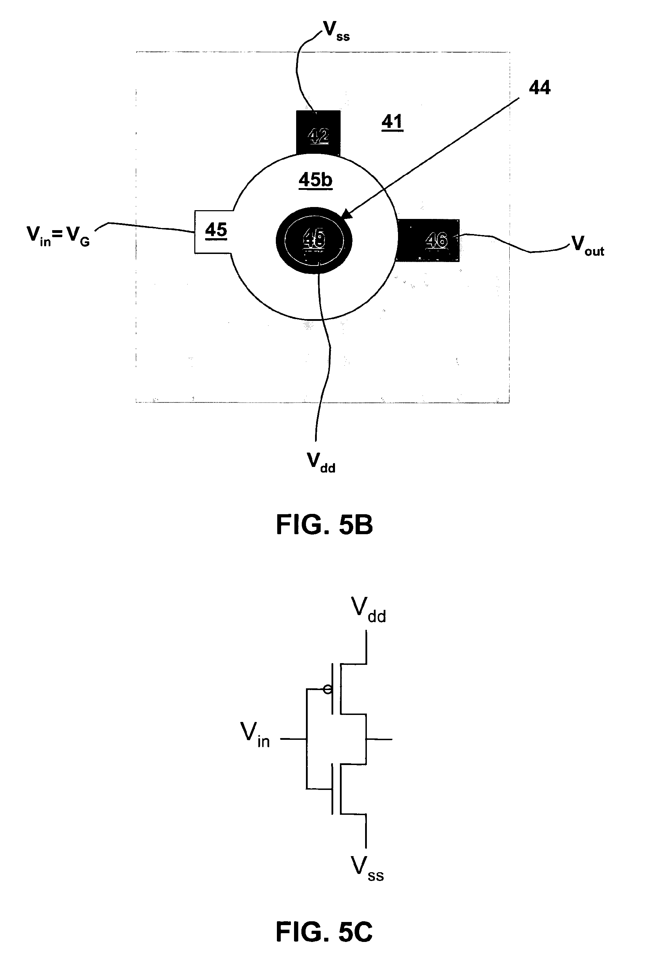

Figure 5A shows a cross-section (front-view) of a vertical nanowire semiconductor device, i.e. a vertical nanowire field-effect transistor acting as an inverter and comprising a vertical stack of a first, in this embodiment n-type, nanowire and a second, in this embodiment p-type, nanowire. Figure 5B shows a top view of the device illustrated in Figure 5A and Figure 5C shows the electrical equivalent of the structure according to Figure 5A.

The structure illustrated in Figure 5A comprises a substrate 41, preferably said substrate 41 may be a semiconductor substrate such as a silicon substrate or a silicon on insulator (SOI) substrate. In the substrate 41 a first contact, e.g. source contact 42 (Vₛₛ), may be provided. Said first contact, e.g. source contact 42, may be a conductive material containing structure, e.g. a silicide containing structure (e.g. NiSi, CoSi₂, TiSi₂,...) and preferably such silicide containing structure may be a silicide structure surrounded by Shallow Trench Isolation (STI) units in case the semiconductor substrate 41 is a Si substrate. However, in other embodiments, the first contact, e.g. source contact 42, may also be formed of a metal containing structure, a germanide containing structure, polysilicon or a combination thereof. On said first contact, e.g. source contact 42, e.g. silicide containing structure, the semiconductor device may comprise a first, e.g. n-type, nanowire 43 which may be surrounded by a gate insulating material 44, e.g. gate oxide. Examples of suitable materials to form the gate insulating material 44 may be oxides such as e.g. TEOS, SiO₂, SiON, high-k dielectrics such as HfO₂, Ta₂O₅ and/or combinations thereof. According to the structure illustrated in Figure 5A, at least part of the nanowire structure 43 may be surrounded by a first gate structure 45a (also referred to as a surround gate). This first gate structure 45a can, for example, be a poly-Si gate, a metal gate, a FUSI gate, etc. The n-type nanowire 43 connects to a second contact, e.g. an output contact 46 (Vₒᵤₜ) of the field-effect transistor. The second contact, output contact 46, may be formed of a conductive structure such as e.g. a metal containing structure, a silicide containing structure, a germanide containing structure, polysilicon or a combination thereof.

The combination of the components described above forms a functional entity, namely a nanowire device structure, in the example given an n-type, nanowire FET (NW-FET) structure. According to this embodiment, the active region of the formed surround-gate nanowire device structure comprises an n-type nanowire 43 which forms the channel of the n-type nanowire FET structure.

A second functional entity, i.e. a second nanowire device structure, may then be formed on top of this first entity, i.e. the first nanowire device structure. Starting from the second contact, e.g. output contact 46, which may, for example, be a silicide containing structure, a second, e.g. p-type, nanowire 47 is deposited. The second, in this embodiment p-type, nanowire 47 may be surrounded by a thin gate insulating layer 44, e.g. a gate oxide layer. Commonly used gate insulating materials which can be used therefor may, for example, be a TEOS oxide layer, SiO₂, SiON, high-k layers such as HfO₂, Ta₂O₅ and/or combinations thereof. According to an embodiment of the present aspect of the invention, at least part of the second, in this embodiment p-type, nanowire 47 may be surrounded by a second gate structure 45b (also referred to as a surround gate). This second gate structure 45b can be a conductive gate structure such as, for example, a poly-Si gate, a metal gate, a FUSI gate, etc. The second, e.g. p-type, nanowire 47 connects to a third contact, e.g. drain contact 48 (V_{dd}), of the field-effect transistor. This second functional entity represents a second nanowire device structure, in the example given a second or p-type nanowire FET structure. The active region of this second nanowire FET structure also comprises a second, in this preferred embodiment p-type, nanowire 47, which forms the channel of the second, in this embodiment p-type, nanowire FET structure.

The first gate structure 45a and the second gate structure 45b may, according to this embodiment, be connected to each other by means of a vertical structure filled up with a conductive material (e.g. a copper or tungsten via), also referred to as conductive structure 45. The vertical stack of both entities, i.e. of both the first and second nanowire device structures, in the example given the first and second nanowire FET structures with connected gate structures 45a, 45b, results in the nanowire-analog of the CMOS. The structure of Figure 5A can therefore be thought of as a vertical surround-gate complementary field-effect-transistor and it functions as an inverter which is schematically shown in Figure 5C.

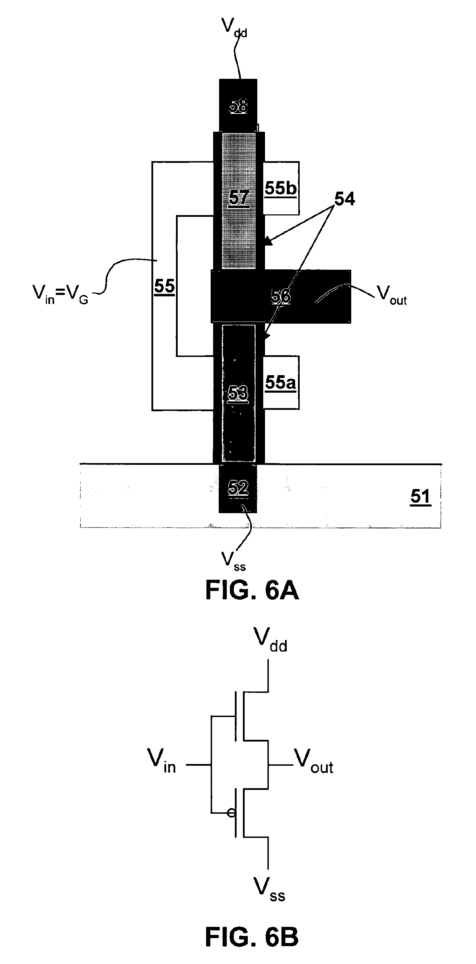

In an alternative embodiment of the present aspect of the invention a vertical nanowire semiconductor device, i.e. a vertical surround-gate field-effect-transistor, is disclosed which has a similar structure compared to the structure of Figure 5A but with the position of the first, n-type, nanowire 43 and the second, p-type, nanowire 47 switched. The resulting structure, shown in Figure 6A, can therefore be thought of as a vertical surround-gate field-effect-transistor with a different electrical behavior compared to the vertical surround-gate field-effect-transistor illustrated in Fig. 5A-C, namely a follower instead of an inverter (shown in electrical representation in Figure 6B).

The vertical surround-gate field-effect-transistor disclosed in this alternative embodiment is shown in Figure 6A and Figure 6B. The vertical surround-gate field-effect-transistor according to this embodiment comprises a substrate 51 in which a first contact is situated, e.g. source contact 52 (Vₛₛ), which may be formed of a conductive structure such as a silicide containing structure, but may also be formed of a metal containing structure, a germanide containing structure, polysilicon or a combination thereof. On said first contact, e.g. source contact 52, for example a silicide containing structure, there is a first, in this alternative embodiment p-type, nanowire 53 which may be surrounded by a gate insulator, e.g. gate oxide 54. At least part of this first, in this alternative embodiment p-type, nanowire structure 53 may be surrounded by a first gate structure 55a (also referred to as a surround gate). The first, in this embodiment p-type, nanowire 53 may connect to a second contact, e.g. an output contact 56 (Vₒᵤₜ), which may be formed of a conductive structure, for example of a metal containing structure, a silicide containing structure, a germanide containing structure, polysilicon or a combination thereof. The combination of the so-far described components forms a first functional entity, namely a first nanowire device structure or, according to this embodiment, a p-type nanowire FET (NW-FET) structure.

Starting on the second contact, e.g. output contact 56, a second, in this alternative embodiment n-type, nanowire 57 structure is deposited. The second, in this alternative embodiment n-type, nanowire 57 is also surrounded by gate insulator, e.g. gate oxide 54 and at least part of the second, in this alternative embodiment n-type, nanowire structure 57 may be surrounded by a second gate structure 55b (also referred to as a surround gate). The second, in this embodiment n-type, nanowire 57 may connect to a third contact, e.g. drain contact 58 (V_{dd}), of the field-effect transistor. The third contact, e.g. drain contact 58, may be formed of a conductive structure, such as a metal containing structure, a silicide containing structure, a germanide containing structure, polysilicon or a combination thereof. The second, in this embodiment n-type, nanowire 57 and the third contact, e.g. drain contact 58, form a second functional entity which, according to this embodiment, represents an n-type nanowire FET structure. The active region of this second nanowire FET structure also comprises a nanowire 57, which forms the channel of the nanowire FET structure. The first gate structure 55a and the second gate structure 55b are connected to each other by means of vertical structure 55 filled up with a conductive material (e.g. a copper or tungsten via), also referred to as conductive structure 55.

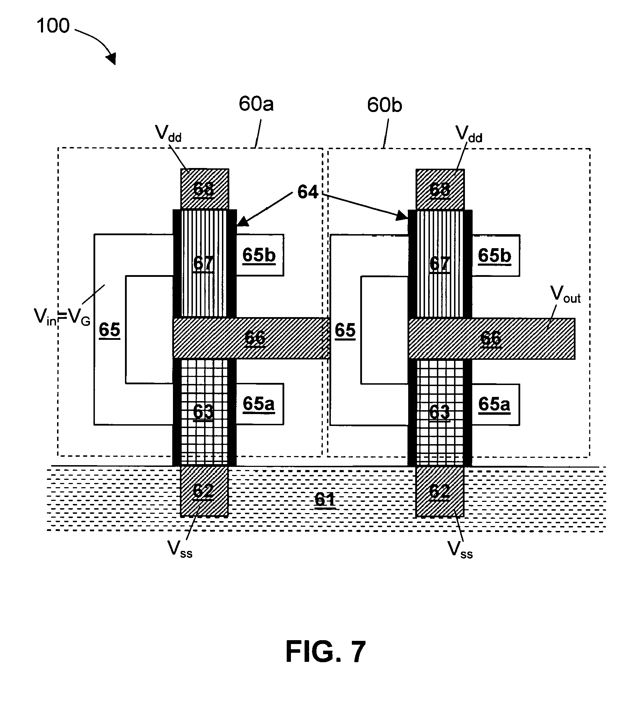

In a further alternative embodiment a vertical nanowire semiconductor device, e.g. a vertical surround-gate field-effect-transistor device structure 100, is disclosed in which two or more vertical nanowire semiconductor device units, e.g. vertical surround-gate field-effect-transistor units, as described in the previous embodiments and shown schematically in Figure 5A or Figure 6A are combined or, in other words, are connected to each other. The output of a first unit may form the input to a second unit, etc. Figure 7 shows a cross-section (front-view) of such a vertical nanowire semiconductor device, e.g. a vertical surround-gate field-effect-transistor device structure 100, wherein two vertical nanowire semiconductor device units 60a, 60b, e.g. vertical surround-gate nanowire FET units, are connected to each other in series. The vertical nanowire semiconductor device, e.g. vertical surround-gate field-effect-transistor device structure 100, according to this embodiment comprises a substrate 61 in which two first contacts, e.g. source contacts 62 (Vₛₛ), which may be conductive structures such as e.g silicide containing structures, metal containing structures, germanide containing structures, polysilicon or a combination thereof, are situated. On said first contacts, e.g. source contacts 62, there is a first, n-type (or p-type) nanowire 63 which may be surrounded by a gate insulator, e.g. gate oxide material 64. At least part of this first nanowire 63 may be surrounded by a first gate structure 65a (also referred to as a surround gate). The nanowire 63 may connect to a second contact, e.g. an output contact 66 (Vₒᵤₜ), of the semiconductor device, e.g. field-effect transistor. According to this embodiment, the second contact, e.g. output contact 66, of the first nanowire semiconductor device, e.g. nanowire FET unit 60a, is used to make contact with the second nanowire semiconductor device, e.g. nanowire FET unit 60b.

Said second contact, e.g. output contact 66, which may be a conductive structure, for example, a silicide containing structure, but may also be a metal containing structure, a germanide containing structure, polysilicon or a combination thereof, is also the starting point for a second p-type (or n-type) nanowire 67 on top of the first nanowire 63. The second p-type (or n-type) nanowire 67 may also be surrounded by a gate insulator, e.g. gate oxide material 64 and at least part of the second p-type (or n-type) nanowire structure 67 may be surrounded by a second gate structure 65b (also referred to as a surround gate). The second p-type (or n-type) nanowire 67 may connect to a third contact, e.g. drain contact 68 (V_{dd}), of the field-effect transistor. The first gate structure 65a and the second gate structure 65b may be connected to each other by means of vertical structure 65 filled up with a conductive material (e.g. a copper or tungsten via), also referred to as conductive structure 65.

It has to be noted that the first and second nanowire semiconductor device units 60a, 60b do not have to be identical to each other. For example, the material the nanowires 63, 67 are formed of may be different from each other, or the type of doping of nanowires 63, 67 on a same level may be different. For example, the first nanowire 63 of the first unit 60a may be formed of a different material than the first nanowire 63 of the second unit 60b and/or the first nanowire 63 of the first unit 60a may be of a different type of doping than the first nanowire 63 of the second unit 60b.

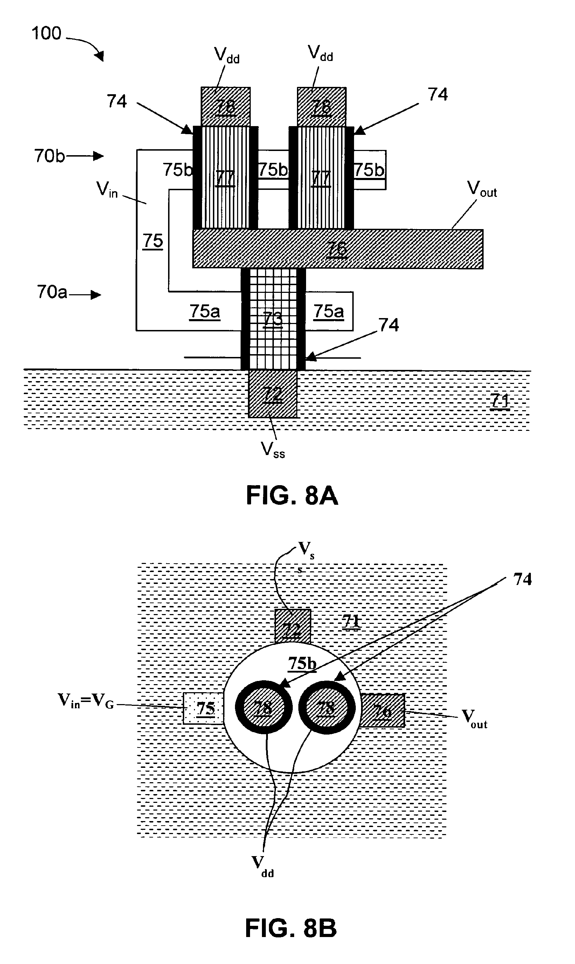

In yet another alternative embodiment of the present invention, a vertical nanowire semiconductor device, i.e. a vertical surround-gate field-effect-transistor 100, is disclosed in which the number of nanowires 73, 77 in a top section 70b or bottom section 70a of the basic structure as described in the previous sections and shown in Figure 5A and/or Figure 6A can be larger than 1. Figure 8A shows an example of such a vertical nanowire semiconductor device, e.g. vertical surround-gate field-effect-transistor 100, comprising two nanowires 77 in the top section 70b of the device 100 and one nanowire 73 in the bottom section 70a of the device 100. Figure 8B shows a top view of the same structure. The vertical nanowire semiconductor device, e.g. vertical surround-gate field-effect-transistor 100, illustrated in Figures 8A and 8B comprises a substrate 71 in which a first contact, e.g. source contact 72 (Vₛₛ), which may be a conductive structure such as a silicide containing structure, but may also be a metal containing structure, a germanide containing structure, polysilicon or a combination thereof, is situated. On said first contact, e.g. source contact 72, there is a first n-type (or p-type) nanowire 73 which may be surrounded by gate insulator, e.g. gate oxide material 74. At least part of this first nanowire structure 73 may be surrounded by a first gate structure 75a (also referred to as a surround gate). The n-type (or p-type) nanowire 73 may connect to a second contact, e.g. an output contact 76 (Vₒᵤₜ), of the field-effect transistor. The combination of the so-far described components forms a first nanowire device structure, namely a n-type (or p-type) nanowire FET (NW-FET) structure. Starting on the second contact, e.g. output contact 76, two (or more) p-type (or n-type) nanowires 77 may be deposited. In the example given in Figures 8A and 8B the top section 70b of the vertical nanowire semiconductor device, e.g. vertical surround-gate field-effect-transistor 100, may comprise two nanowires 77. It has to be understood that this is only an example and that it is not limiting the invention. For example, the top section 70b of the vertical nanowire semiconductor device, e.g. vertical surround-gate field-effect-transistor 100, may comprise more than two nanowires 77 and also the bottom section 70a of the vertical nanowire semiconductor device, e.g. vertical surround-gate field-effect-transistor 100, may comprise more than one nanowire 73. The bottom section 70a and top section 70b of the vertical nanowire semiconductor device, e.g. vertical surround-gate field-effect-transistor 100, may comprise the same number of nanowires 73, 77 or may comprise different numbers of nanowires 73, 77. These p-type (or n-type) nanowires 77 of the top section 70a of the vertical nanowire semiconductor device, e.g. vertical surround-gate field-effect-transistor 100, are also surrounded by gate insulator, e.g. gate oxide material 74 and at least part of the second p-type (or n-type) nanowires structures 77 may be surrounded by a second gate structure 75b (also referred to as a surround gate). The p-type (or n-type) nanowires 77 may connect to a third contact, e.g. drain contact 78 (V_{dd}), of the field-effect transistor and form, together with the third contact, e.g. drain contact 78, a second nanowire device structure. The third contact, e.g. drain contact 78 may be a conductive structure, for example a metal containing structure, a silicide containing structure, a germanide containing structure, polysilicon or a combination thereof. Preferably, the third contact, e.g. drain contact 78, may be formed of a silicide structure. This second functional entity represents a n-type (or p-type) nanowire FET structure. The first gate structure 75a and the second gate structure 75b may be connected to each other by means of a structure 75 filled with a conductive material (e.g. a copper or tungsten via), also referred to as conductive structure 75.

As already mentioned, the example shown in Figure 8A illustrates a vertical nanowire semiconductor device, e.g. vertical surround-gate field-effect-transistor 100, with two nanowires 77 in the top section 70b and one nanowire 73 in the bottom section 70a, but the bottom section 70a and the top section 70b may also comprise other numbers of nanowires 73, 77 in top and bottom sections. For example, the vertical nanowire semiconductor device, e.g.vertical surround-gate field-effect-transistor 100, may comprise e.g. three nanowires 77 in the top section 70b and four nanowires 73 in the bottom section 70a, or may comprise three nanowires 77 in the top section 70b and three nanowires 73 in the bottom section 70a, etc. Any suitable number of nanowires in top and bottom sections may be provided.

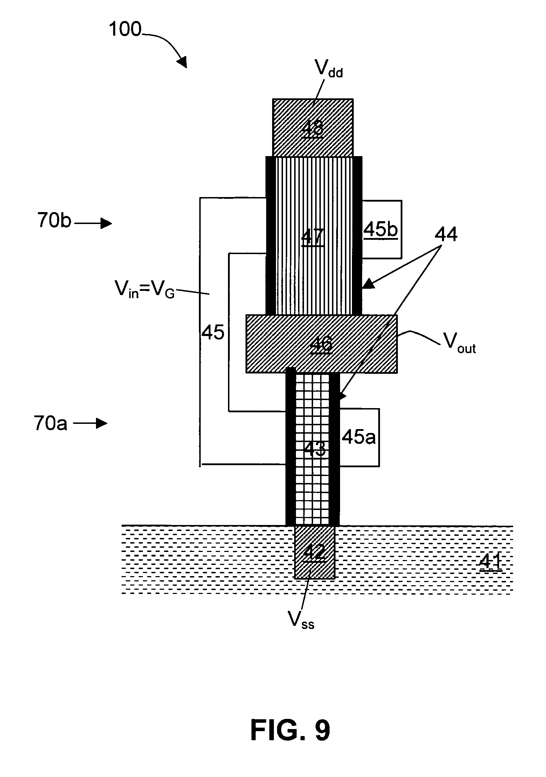

In another alternative embodiment a vertical nanowire semiconductor device, e.g. a vertical surround-gate field-effect-transistor 100, is disclosed in which the diameter of the individual nanowires 43, 47 either in the bottom section 70a and/or top section 70b of the basic structure as described in the previous sections can be different. This is illustrated in Figure 9 wherein the top section 70b of the vertical nanowire semiconductor device, e.g. vertical surround-gate field-effect-transistor 100, comprises a nanowire 47 with a diameter that is larger than the diameter of the nanowire 43 in the bottom section 70a of the vertical nanowire semiconductor device, e.g. vertical surround-gate field-effect-transistor 100. It has to be understood that the vertical nanowire semiconductor device, e.g. vertical surround-gate field-effect-transistor 100, illustrated in Figure 9 is only an example and does not limit the invention. For example, the diameter of the nanowire 43 in the bottom section 70a of the vertical nanowire semiconductor device, e.g. vertical surround-gate field-effect-transistor 100, may be larger than the diameter of the nanowire 47 in the top section 70b of the vertical nanowire semiconductor device, e.g. vertical surround-gate field-effect-transistor 100. Furthermore, the bottom section 70a and the top section 70b of the vertical nanowire semiconductor device, e.g. vertical surround-gate field-effect-transistor 100, may comprise more than one nanowire 43, 47 of which at least one may have a different diameter than the others. For example, in some embodiments according to the invention, each nanowire 43, 47 in the bottom section 70a and in the top section 70b of the vertical nanowire semiconductor device, e.g. vertical surround-gate field-effect-transistor 100, may have a different diameter.

The advantage of using nanowires 43, 47 with different diameters in the bottom section 70a and top section 70b is that, in that way, a same current can be obtained in both sections 70a, 70b when, for example, the nanowires 43, 47 of the bottom section 70a and the top section 70b are formed of a different material or if the nanowires 43, 47 in the bottom section 70a and the top section 70b are of a different doping type. For example, when the nanowires 47 in the bottom section 70a are formed of p-Si and the nanowires 43 in the top section 70b are formed of n-Si, the diameter of the nanowires 47 in the bottom section 70a may be larger than the diameter of the nanowires 43 of the top section 70b because the mobility of holes is lower than the mobility of electrons. In order to get the same current in the bottom section 70a as in the top section 70b, the diameter of the nanowires 47 in the bottom section 70a may be made larger. In case the nanowires 43 in the top section 70b and the nanowires 47 in the bottom section 70a are formed of a different material, the diameter of the nanowires 43, 47 can be adjusted so as to obtain a same current in the bottom section 70a and the top section 70b.

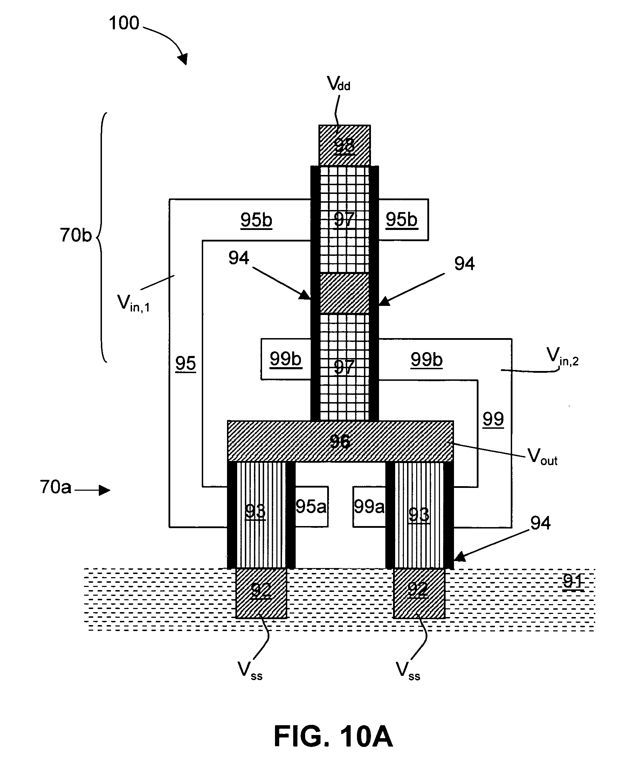

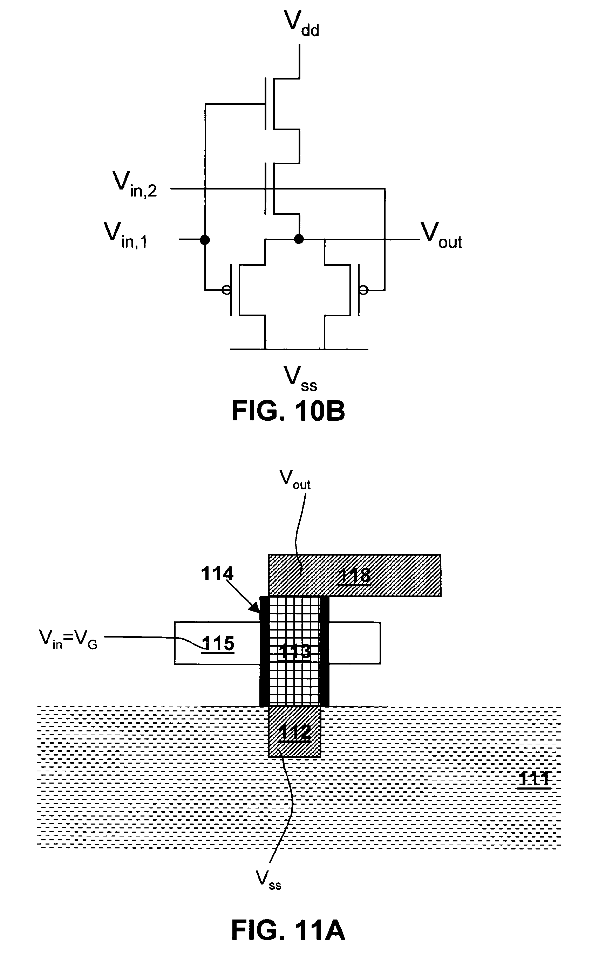

In still another alternative embodiment a vertical nanowire semiconductor device, i.e. a vertical surround-gate field-effect-transistor device structure 100, is disclosed in which the number of vertical stacks of individual nanowire device structures, e.g. nanowire FET structures, is increased to more than two. Figure 10A shows an AND-gate structure in which the bottom section 70a of the vertical nanowire semiconductor device, e.g. vertical surround-gate field-effect-transistor 100, comprises two nanowire device structures, e.g. horizontally stacked p-type nanowire FET structures, each structure comprising a first contact, e.g. source contact 92, in a substrate 91, a surround gate structure 95a, 99a and one common second contact, e.g. output contact 96 (Vₒᵤₜ), which may be formed of a conductive structure such as a silicide containing structure, a metal containing structure, a germanide containing structure, polysilicon or a combination thereof. Preferably the second contact, output contact 96, is formed of a silicide containing structure. The vertical nanowire semiconductor device, e.g. vertical surround-gate field-effect-transistor device structure 100, according to this embodiment furthermore comprises two vertically stacked nanowire device structures, e.g. n-type NW-FET units, in the top section 70b. The two vertically stacked nanowire device structures, e.g. n-type nanowires 97, in the top section 70b each comprise a gate structure 95b, 99b which may be connected through a via 95, 99 to the surround gate 95a, 99a of the nanowires 93 in the bottom section 70a. The electrical equivalent of the AND structure of Figure 10A is shown in Figure 10B. A person skilled in the art can understand that several other combinations are possible such as two or more vertically stacked p-type (or n-type) nanowire FET structures, in the bottom section 70a and two or more horizontally stacked n-type (or p-type) nanowire FET structures in the top section 70b. These structures may, for example, form an OR-gate, a NOR-gate or a NAND-gate.

An alternative embodiment involves combination of planar devices, e.g. planar MOSFETs and/or planar double-gate MOSFET structures (FINFETs) or tri-gate MOSFET structures, with interconnect metallization, and on top of the interconnect metallization a single vertical nanowire device structure, e.g. nanowire FET structure, or a stack of vertical nanowire device structures, e.g. nanowire FETs, may be formed.

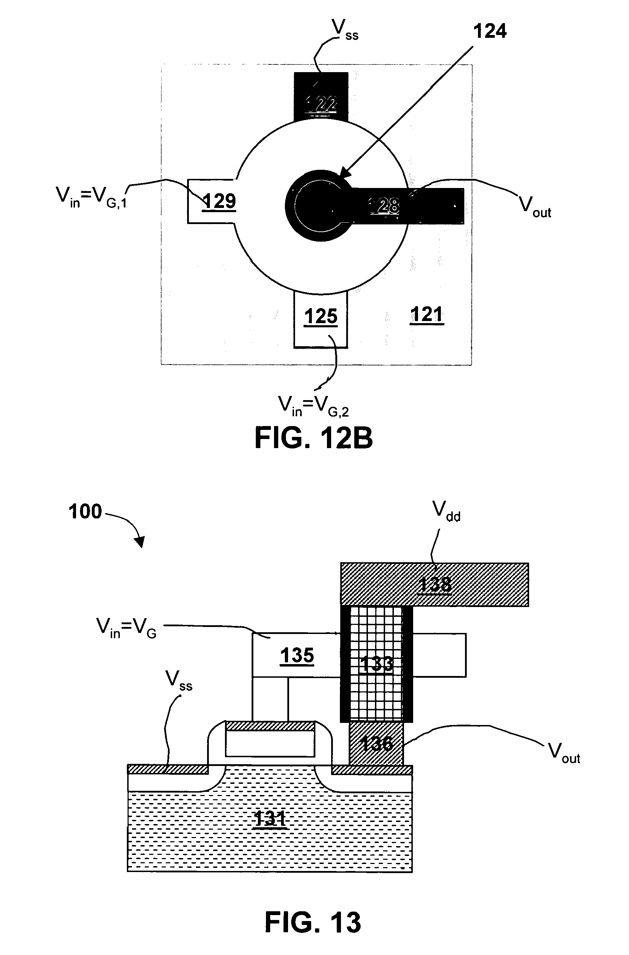

In yet another alternative embodiment, a single vertical nanowire device structure, e.g. nanowire FET structure, may be formed directly on top of a planar MOSFET or FINFET or tri-gate device, using the source or drain regions of the planar device as the source region for the vertical nanowire device structure, e.g. nanowire FET structure (see Fig. 13).

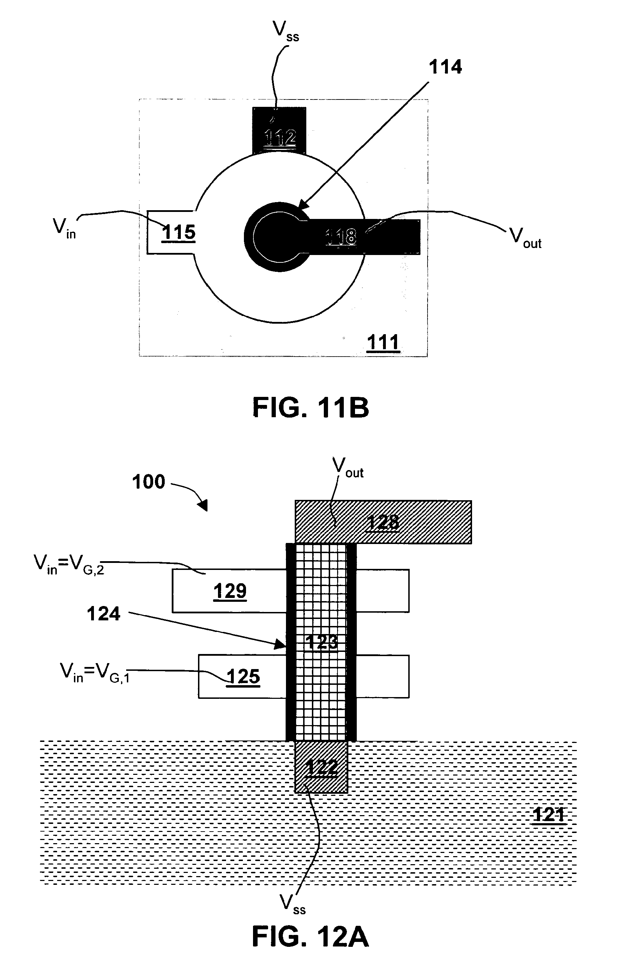

In these alternative embodiments, a vertical nanowire semiconductor device, e.g. vertical surround-gate field-effect-transistor, is disclosed with only one nanowire device structure, which may be combined with a transistor device structure made in conventional planar CMOS technology. The nanowire device structure according to these alternative embodiments is shown schematically in Figure 11A (front view) and Figure 11B (top view). The nanowire device structure in Figure 11A comprises a substrate 111 in which a first contact, e.g. source contact 112 (Vₛₛ), is situated, which may be formed of a conductive structure, e.g. a silicide containing structure. The first contact, e.g. source contact 112, may also be formed of e.g. a metal containing structure, a germanide containing structure, polysilicon or a combination thereof. On said first contact, e.g. source contact 112, there is a, for example, p-type (or n-type) nanowire 113 which may be surrounded by gate insulator, e.g. gate oxide material 114. At least part of the nanowire 113 may be surrounded by a gate structure 115 (also referred to as a surround gate). Preferably, but not necessarily, said surround gate 115 may be all-around the diameter of the nanowire 113. Furthermore, the nanowire 113 has a length and preferably 10% to 95%, or 10% to 99%, or 60% to 90%, or 60% to 99% of the nanowire length may be covered by said gate structure.

The amount of the nanowire which is covered by the gate structure may, in general, be determined by a trade-off between a series resistance Rs of the nanowire and a parasitic capacitance between the gate structure and a first contact, e.g. source contact, or a second contact, e.g. drain contact. The resistance of the part of the nanowire which is not covered by the gate structure may be determined by the nanowire doping and will to first approximation not be influenced by the gate structure since the gate structure does not cover the nanowire. The longer the non-covered section, the larger the series resistance Rs of the nanowire. On the other hand, the shorter the non-covered section of the nanowire, the stronger the capacitive coupling between the gate structure electrode and the source or drain contact. The optimal coverage is therefore a trade-off between series resistance and parasitic capacitive coupling and depends on the application.

Thus, the amount of nanowire that is covered by the gate structure or, in other words, the amount of coverage may be determined by the material the nanowire is formed of, by the diameter of the nanowire and by the application the device will have to be used for.

The p-type (or n-type) nanowire 113 may connect to a third contact, e.g. an output contact 118 (Vₒᵤₜ), of the semiconductor device, e.g. field-effect transistor. The third contact, e.g. output contact 118, may be formed of a conductive structure such as a silicide containing structure, a germanide containing structure, a metal containing structure, polysilicon or a combination thereof. The combination of the so-far described components forms a functional entity, namely a nanowire device structure, in the example given a p-type (or n-type) nanowire FET (NW-FET) structure.

In an alternative embodiment, a vertical nanowire semiconductor device, e.g. vertical surround-gate field-effect-transistor device structure 100, is disclosed in which more than one gate (surround gate) structure is surrounding an individual nanowire device structure, e.g. nanowire FET structure. Figure 12A (front view in cross-section) shows the simplest structure of such a vertical multiple-separate-gate surround FET structure having two gates on a same nanowire section for a vertical nanowire semiconductor device, e.g. transistor. The structure in Figure 12A represents a FET of which the operation, with which is meant the switching between ON and OFF state of the FET, is controlled by both gates and may be thought of as comprising a vertical stack of two nanowire device structures, e.g. nanowire FET structures. The nanowire device structure according to this embodiment comprises a substrate 121 in which a first contact, e.g. source contact 122 (Vₛₛ), preferably formed of a silicide containing structure, is situated. On said first contact, e.g. source contact 122, there is a p-type (or n-type) nanowire 123 which may be surrounded by gate insulator, e.g. gate oxide material 124. At least part of this nanowire structure 123 may be surrounded by a first gate structure 125 (also referred to as a first surround gate) and by a second gate structure 129 (also referred to as a second surround gate). The p-type (or n-type) nanowire 123 connects to a second contact, e.g. an output contact 128 Vₒᵤₜ, of the field-effect transistor. The second contact, e.g. output contact 128, may be formed of a conductive structure, e.g. a silicide containing structure, a germanide containing structure, a metal containing structure, polysilicon or a combination thereof. Figure 12B shows the top view of this structure.

The structure illustrated in Figures 12A and 12B may furthermore be positioned on top of any device structure or nanowire device structure as described in this invention.

As an alternative, layers comprising nanowire device structures, e.g. nanowire FET structures, and metal interconnection layer(s) can be intermixed. As an example a nanowire device structure, e.g. nanowire FET structure, comprising layer (e.g. comprising n- and p-type nanowire device structure, e.g. nanowire FET structure, on a same level) can be connected to one or more metal interconnect layer(s), on top of said metal interconnect layer(s) another layer comprising nanowire device structures, e.g. nanowire FET structures, can be built, followed by again one or more metal interconnect layer(s), etc. Another example can be a nanowire device structure, e.g. nanowire FET structure, bi-layer (Vertical CMOS) with several metal interconnect layers on top of the nanowire device structure, e.g. nanowire FET structure, bi-layer followed by another nanowire device structure, e.g. nanowire FET structure, comprising layer,.... It should be clear that several combinations are possible comprising bilayers, trilayers, etc intermixed with interconnect layers.

In another and also preferred alternative planar MOSFETs are combined with vertical nanowire FETs. As an example, in Figure 13 the combination of a planar MOSFET (e.g a n-MOSFET) structure with a vertical nanowire FET (e.g. p-type NW-FET) structure as described in the present invention is shown. The nanowire FET structure starts on a conductive, e.g. silicide, layer on a first electrode region, e.g. drain region, of a MOSFET structure. Optionally an additional conductive structure, e.g. silicide, germanide or metal containing structure 136 can be deposited to enhance the deposition of the nanowire 133. The doped (e.g. n-type here) nanowire is at least partly surrounded by a gate structure 135 (referred to as surround gate), said gate structure 135 making contact to the gate structure of the MOSFET structure. On said nanowire 133 a second contact, e.g. drain contact 138 V_{dd}, is deposited.

According to another embodiment of the invention, the device according to the present invention may also be different from the vertical surround-gate field-effect transistor as described above. For example, the device may also be a semiconductor device comprising a first nanowire device structure comprising at least one nanowire 16 that is at least partly surrounded by a gate structure 10. On top of the first nanowire device structure, in the example given a nanowire FET structure, instead of another nanowire FET structure as was the case in the examples given above, a second nanowire device structure may be positioned comprising at least one nanowire 16 formed of a conductive material such as a silicide, a germanide, a metal or metal alloy. In this embodiment, the at least one nanowire 16 of the second nanowire device structure is not surrounded by a gate structure 10.

In an alternative embodiment, the first nanowire device structure may comprise at least one nanowire 16 formed of a conductive material such as a silicide, a germanide, a metal or a metal alloy which is not surrounded by a gate structure 10. On top of the first nanowire device structure, a second nanowire device structure may be positioned, comprising at least one nanowire 16 which is at least partly surrounded by a gate structure 10.

In further embodiments, the structures as described in the above-described embodiments may furthermore comprise at least one further nanowire device structure positioned on top of the described first and second nanowire device structures, the at least one further nanowire device structure comprising at least one nanowire 16 which may or may not be at least partly surrounded by a gate structure 10. The method according to the invention may be used to form vertical nanowire semiconductor devices comprising as many levels as required to form a device suitable for different applications.

In still further embodiments, the method may be used to form vertical nanowire semiconductor devices comprising a first and a second device structure positioned on top of each other. According to these further embodiments he first device structure may be a planar transistor device structure, such as e.g. a planar MOSFET or a planar double-gate MOSFET structure (e.g. a finFET) or tri-gate MOSFET structure. The second device structure may be a nanowire device structure comprising at least one vertical nanowire 16 which may or may not, depending on the application, be at least partly surrounded by a gate structure 10. The vertical nanowire semiconductor device according to these further embodiments may furthermore comprise additional device structures positioned on top of or below the first and second device structure.

It has to be understood that the nanowires 16 in the nanowire device structures of these further embodiments may all have the same properties as the nanowires 16 described in the earlier embodiments. The nanowires may have a diameter between 0.2 and 500 nm, preferably between 1 and 500 nm, most preferred the diameter of the at least one nanowire may be between 5 and 200 nm. The length of the nanowires 16 may be between 10 nm and 2 µm, preferably between 20 nm and 2 µm, most preferred the length of the nanowires may be between 50 nm and 1 µm. Furthermore, the different nanowire device structures may comprise nanowires 16 having a same or a different diameter, may comprise a same or a different number of nanowires 16 and may comprise a horizontal stack of nanowires 16. Moreover, gate structures 10 at least partly surrounding the nanowires of different nanowire device structures may be connected to each other by means of a conductive structure.

It is to be understood that although preferred embodiments, specific constructions and configurations, as well as materials, have been discussed herein for devices according to the present invention, various changes or modifications in form and detail may be made without departing from the scope and spirit of this invention. For example, a person skilled in the art can understand that a combination of all the presented alternatives can be implemented, e.g. more top nanowires than bottom nanowires whereby the top nanowires have different diameters than the bottom nanowires, having one or more surround gates surrounding it etc. These alternatives are also part of the present invention.

The vertical stacking of nanowires is illustrated in this application to create a logic unit for application in the field-effect-transistor field but a person skilled in the art can implement the present invention in several other possible application fields wherein these vertical stacked nanowires can be used to create a channel or to form an electrical connection.

## Claims

1. A nanostructure semiconductor device (100) having a substrate (1) lying in a plane and comprising at least a first and a second device structure positioned on top of each other, wherein at least the first device structure is a transistor structure and at least the second device structure is an elongate nanostructure device structure comprising at least one elongate nanostructure (16, 20) positioned substantially perpendicular to the plane of the substrate (1).

2. A nanostructure semiconductor device (100) according to claim 1, wherein the at least one elongate nanostructure (16, 20) is at least partly surrounded by a gate structure (10).

3. A nanostructure semiconductor device (100) according to claim 2, the at least one elongate nanostructure (16, 20) having a length, wherein the gate structure (10) covers between 10% and 99% of the elongate nanostructure length.

4. A nanostructure semiconductor device (100) according to claim 3, wherein the gate structure (10) covers between 60% and 99% of the elongate nanostructure length.

5. A nanostructure semiconductor device (100) according to any of the previous claims, wherein the elongate nanostructure device structure comprises a plurality of elongate nanostructures (16, 20).

6. A nanostructure semiconductor device (100) according to any of the previous claims, wherein the diameter of the at least one elongate nanostructure (16, 20) is between 0.2 and 500 nm.

7. A nanostructure semiconductor device (100) according to claim 19, wherein the diameter of the at least one elongate nanostructure (16, 20) is between 5 and 200 nm.

8. A nanostructure semiconductor device (100) according to any of the previous claims, wherein the length of the at least one elongate nanostructure (16, 20) is between 10 nm and 2 µm.

9. A nanostructure semiconductor device (100) according to claim 21, wherein the length of the at least one elongate nanostructure (16, 20) is between 50 nm and 1 µm.

10. A nanostructure semiconductor device (100) according to any of the previous claims, wherein the at least one elongate nanostructure (16, 20) is doped.

11. A nanostructure semiconductor device (100) according to claim 10, wherein the at least one elongate nanostructure (16, 20) has a dopant profile which is uniform or gradual over the length of the elongate nanostructure.

12. A nanostructure semiconductor device (100) according to any of the previous claims, wherein the elongate nanostructure device structure is a multiple-separate-gate surround FET transistor comprising at least two gate structures, each gate structure at least partly surrounding a same elongate nanostructure (16, 20).

13. A nanostructure semiconductor device (100) according to any of the previous claims, wherein the device (100) comprises at least a first elongate nanostructure device structure and a second elongate nanostructure device structure positioned on top of each other, each elongate nanostructure device structure comprising at least one elongate nanostructure (16, 20) positioned substantially perpendicular to the plane of the substrate (1), the at least one elongate nanostructure (16, 20) of at least one of the first and second elongate nanostructure device structures being at least partly surrounded by a gate structure (10).

14. A nanostructure semiconductor device (100) according to claim 13, the nanostructure semiconductor device (100) comprising at least one elongate nanostructure device structure without a gate structure (10).

15. A nanostructure semiconductor device (100) according to claim 13, wherein the first and second elongate nanostructure device structures each are at least partly surrounded by a gate structure (10).

16. A nanostructure semiconductor device (100) according to any of claims 13 to 15, wherein the first elongate nanostructure device structure comprises at least one elongate nanostructure (20) of a first type and the second elongate nanostructure device structure comprises at least one elongate nanostructure (20) of a second type, the first and second doping type being different from each other.

17. A nanostructure semiconductor device (100) according to any of claims 13 to 16, wherein the first elongate nanostructure device structure comprises at least one elongate nanostructure (16, 20) formed of a first material and wherein the second elongate nanostructure device structure comprises at least one elongate nanostructure (16, 20) formed of a second material, the first and second material being different from each other.

18. A nanostructure semiconductor device (100) according to any of claims 13 to 17, the at least one elongate nanostructure (16, 20) of the first elongate nanostructure device structure having a first diameter and the at least one elongate nanostructure (16, 20) of the second elongate nanostructure device structure having a second diameter, the first and second diameter being equal to each other.

19. A nanostructure semiconductor device (100) according to any of claims 13 to 18, the at least one elongate nanostructure (16, 20) of the first elongate nanostructure device structure having a first diameter and the at least one elongate nanostructure (16, 20) of the second elongate nanostructure device structure having a second diameter, the first and second diameter being different from each other.

20. A nanostructure semiconductor device (100) according to any of the previous claims, wherein the nanostructure semiconductor device (100) is a vertical surround-gate elongate nanostructure complementary field-effect transistor.

21. A nanostructure semiconductor device (100) according to any of claims 1 to 12, wherein the first device structure is a planar transistor device structure and wherein the second device structure is a elongate nanostructure device structure comprising at least one elongate nanostructure (16, 20) positioned substantially perpendicular to the plane of the substrate (1).

22. A nanostructure semiconductor device (100) according to claim 21, wherein the planar transistor device structure is a planar MOSFET or a planar double gate or tri-gate MOSFET structure.

23. A method for manufacturing a nanostructure semiconductor device (100), the method comprising:
- providing a substrate (1) lying in a plane,
- providing on said substrate (1) a first and second device structure on top of each other, wherein at least the first device structure is a transistor structure and at least the second device structure is an elongate nanostructure device structure comprising at least one elongate nanostructure (16, 20) positioned substantially perpendicular to the plane of the substrate (1).

24. A method according to claim 23, the method furthermore comprising:
- providing the at least one elongate nanostructure (16, 20) with a gate structure (10), the gate structure (10) at least partly surrounding the at least one elongate nanostructure (16, 20).

25. A method according to any of claims 23 or 24, wherein providing a first and second device structure comprises:
- providing a first elongate nanostructure device structure on the substrate (1), the first elongate nanostructure device structure comprising at least one elongate nanostructure (16, 20) positioned substantially perpendicular to the plane of the substrate (1),
- providing at least a second elongate nanostructure device structure on top of the first elongate nanostructure device structure, the second elongate nanostructure device structure comprising at least one elongate nanostructure (16, 20) positioned substantially perpendicular to the plane of the substrate (1), and
- providing at least one of the elongate nanostructure device structures with a gate structure (10) at least partly surrounding the at least one elongate nanostructure (16, 20).

26. A method according to any of claims 23 to 25, wherein providing at least one elongate nanostructure (16, 20) with a gate structure (10) is performed by directly providing the elongate nanostructure with a permanent gate structure (204).

27. A method according to any of claims 23 to 25, wherein providing at least one elongate nanostructure (16, 20) with a gate structure (10) is performed by:
- first providing the at least one elongate nanostructure (16, 20) with a sacrificial gate structure (200), and
- replacing the sacrificial gate structure (200) with a permanent gate structure (204).

28. A method according to claim 25, at least two of the at least first and second elongate nanostructure device structure comprising at least one elongate nanostructure (16, 20) being at least partly surrounded by a gate structure (10), the method furthermore comprising:
connecting the first and second gate structure (10) by means of a conductive structure (45).

29. A method according to any of claims 25 to 28, wherein providing a first elongate nanostructure device structure is performed by
- creating at least a first contact in the substrate, and
- growing an elongate nanostructure surrounded by dielectric material on the first contact.

30. A method according to claim 29, wherein providing a first elongate nanostructure device structure is performed by:
- creating at least one first contact (3) in the substrate (1),
- depositing a first stack of layers on said substrate (1), the first stack of layers comprising a first etch stop layer (4) and a first dielectric layer (5),
- depositing a second stack of layers on top of said first stack of layers (4, 5), the second stack of layers comprising a second etch stop layer (6), a second dielectric layer (7) and a first hardmask layer (8),
- creating a gate structure (10) in said second dielectric layer (7),
- depositing a third stack of layers on top of said second stack of layers (6, 7, 8), the third stack of layers comprising a third dielectric layer (11) and a second hardmask layer (18),
- creating a via (14) in said first (5) and second dielectric layer (7) through said gate structure (10) and landing on said first contact (3),
- depositing a gate insulating material (32) onto the sidewalls of said via (14),
- growing an elongate nanostructure (16) in said via (14) such that the gate structure (10) is surrounding the elongate nanostructure (16) and said elongate nanostructure (16) is making contact with said first contact (3),
- depositing a fourth stack of layers on top of the third stack of layers (11, 18), the fourth stack of layers comprising a fourth dielectric layer (21) and a third hardmask layer (22),
- creating a second contact (24) in said fourth dielectric layer (21) such that a first elongate nanostructure device structure is created.

31. The method according to claim 30, furthermore comprising doping said elongate nanostructure (16) with a doping element (19) such that an at least partly p-type or n-type elongate nanostructure (20) is achieved, the method comprising the steps of:
- depositing a layer comprising the doping element (19), thus forming a dopant layer,
- annealing said dopant layer such that a doped elongate nanostructure (20) is obtained, and
- partly removing said dopant layer such that the height of the doped elongate nanostructure (20) equals the height of said fourth hardmask layer (18).

32. The method according to any of claims 25 to 31, wherein the elongate nanostructures (16, 20) are formed of a semiconducting material.

33. The method according to any of claims 29 to 32, wherein providing at least a second elongate nanostructure device structure is performed on said second contact (24) by:
- depositing a first dielectric layer (5) on the first elongate nanostructure device structure,
- depositing a second stack of layers on top of said first dielectric layer (5), the second stack of layers comprising a second etch stop layer (6), a second dielectric layer (7) and a first hardmask layer (8),
- creating a gate structure (10) in said second dielectric layer (7),
- depositing a third stack of layers on top of said second stack of layers (6, 7, 8), the third stack of layers comprising a third dielectric layer (11) and a second hardmask layer (18),
- creating a via (14) in said first (5) and second dielectric layer (7) through said gate structure (10) and landing on said second contact (24),
- depositing a gate insulating material (32) onto the sidewalls of said via (14),
- growing an elongate nanostructure (16) in said via (14) such that the gate structure (10) is surrounding the elongate nanostructure (16) and said elongate nanostructure (16) is making contact with said second contact (24),
- depositing a fourth stack of layers on top of the third stack of layers (11, 18), the fourth stack of layers comprising a fourth dielectric layer (21) and a third hardmask layer (22),
- creating a third contact (25) in said fourth dielectric layer (21) such that a second elongate nanostructure device structure is created.

34. The method according to any of claims 25 to 33, wherein the material of the at least one elongate nanostructure (16, 20) is formed of one of a group IV material or a binary compound thereof, a group III/V material or binary, tertiary or quaternary compounds thereof, a group II/VI material or binary, tertiary and quaternary compounds thereof, or a metal.

35. The method according to any of claims 30 to 34, wherein said first contact (3) and said second contact (24) are formed of a silicide containing structure, a germanide containing structure, a metal containing structure, polysilicon or a combination thereof.

36. The method according to claim 35, wherein said first contact (3) and said second contact (24) are formed of NiSi, CoSi₂ or TiSi₂.

37. The method of according to any of claim 30 to 36, wherein said dielectric layers (5, 7, 11, 21) are formed of a silicon based oxide or of a low-k material.

38. A method according to any of claims 23 to 37, wherein the elongate nanostructure device structure is a vertical surround-gate elongate nanostructure field-effect transistor.

39. A method according to any of claims 23 or 24, wherein providing a first and second device structure is performed by:
- providing a planar transistor device structure on the substrate (1), and
- providing at least one elongate nanostructure device structure on top of the planar transistor device structure, the at least one elongate nanostructure device structure comprising at least one elongate nanostructure (16, 20) positioned substantially perpendicular to the plane of the substrate (1).

40. A method according to any of claims 23 or 24, wherein providing a first and second device structure is performed by:
- providing at least one nanowire device structure, the at least one nanowire device structure comprising at least one nanowire (16, 20) positioned substantially perpendicular to the plane of the substrate (1), and
- providing a planar transistor device structure on top of at least one nanowire device structure.

41. A method according to any of claims 39 or 40, the method furthermore comprising:
- providing the at least one elongate nanostructure (16, 20) with a gate structure (10), the gate structure (10) at least partially surrounding the at least one elongate nanostructure (16, 20).

42. A method according to any of claims 39 to 41, wherein the planar transistor device structure is a planar MOSFET or a planar double gate or tri-gate MOSFET structure.
